# EUROPEAN PATENT APPLICATION

(11) **EP 4 757 527 A1**
(43) Date of publication of application: **10.06.2026**
(21) Application number: 25214438.1
(22) Date of filing: 07.11.2025
(51) Int. Cl.: H10D 30/01, H10D 30/47, H10D 62/17, H10D 64/64, H10D 62/85, H10D 64/00, H10D 64/23

(54) **SEMICONDUCTOR DEVICE**

(30) Priority: 06.12.2024 KR 20240180893
(71) Applicant: Samsung Electronics Co., Ltd., Suwon-si, Gyeonggi-do 16677 (KR)
(72) Inventor: KIM, Myeongjin, Suwon-si (KR); KIM, Jongseob, Suwon-si (KR); PARK, Junhyuk, Suwon-si (KR); KIM, Joonyong, Suwon-si (KR)
(74) Representative: Marks & Clerk LLP

(57) **Abstract**

A semiconductor device includes a substrate, a channel layer positioned on the substrate, a barrier layer positioned on the channel layer, a gate electrode including a first metal nitride layer positioned on the barrier layer and a second metal nitride layer positioned on the first metal nitride layer, and a source electrode and a drain electrode that are connected to the channel layer and positioned on opposite sides of the gate electrode. A metal of the first metal nitride layer is the same as a metal of the second metal nitride layer. A metal nitride of the first metal nitride layer has a first atomic ratio of at least one element other than nitrogen to nitrogen. A metal nitride of the second metal nitride layer has a second atomic ratio of at least one element other than nitrogen to nitrogen. The second atomic ratio is greater than the first atomic ratio.

## Description

### BACKGROUND

### 1. Field

The present disclosure relates to a semiconductor device.

### 2. Description of the Related Art

In the modern society, semiconductor devices are closely related to our daily lives. In particular, power semiconductor devices which are used in various fields such as the transportation field, for example, electric vehicles, trains, and electric trams, renewable energy systems, for example, solar power generation and wind power generation, and mobile devices, are becoming increasingly important. Power semiconductor devices are semiconductor devices that are used to handle high voltage or high current, and perform functions such as power conversion and control in large power systems and high-power electronic devices. Power semiconductor devices have the capability and durability to handle high power, allowing them to handle large amounts of current and withstand high voltages. For example, power semiconductor devices can handle voltages of hundreds to thousands of volts and currents of tens to thousands of amperes. Power semiconductor devices can improve the efficiency of electrical energy by minimizing power losses. Further, power semiconductor devices can be stably driven in environments such as high temperatures.

These power semiconductor devices can be categorized by their materials, and for example, there are SiC power semiconductor devices and GaN power semiconductor devices. Instead of conventional silicon wafers (Si wafers), SiC or GaN may be used to manufacture power semiconductor devices, whereby it is possible to compensate for the disadvantages of silicon having unstable characteristics at high temperatures. SiC power semiconductor devices are resistant to high temperatures and have low power loss, making them suitable for electric vehicles, renewable energy systems, and the like. GaN power semiconductor devices require high costs, but are efficient in terms of speed, making them suitable for fast charging of mobile devices and the like.

### SUMMARY

The present invention attempts to provide a semiconductor device with improved reliability.

Objects of the present invention are not limited to the above-mentioned object, and other unmentioned technical objects will be clearly construed from the following description by those skilled in the art.

According to aspect of the present disclosure, a semiconductor device includes a substrate, a channel layer that is positioned on the substrate, a barrier layer that is positioned on the channel layer, a gate electrode including a first metal nitride layer which is positioned on the barrier layer and a second metal nitride layer which is positioned on the first metal nitride layer, and a source electrode and a drain electrode that are connected to the channel layer and positioned on opposite sides of the gate electrode. A metal of the first metal nitride layer is the same as a metal of the second metal nitride layer. A metal nitride of the first metal nitride layer has a first atomic ratio of at least one element other than nitrogen to nitrogen. A metal nitride of the second metal nitride layer has a second atomic ratio of at least one element other than nitrogen to nitrogen. The second atomic ratio is greater than the first atomic ratio.

According to an aspect of the present disclosure, a semiconductor device includes a substrate, a channel layer that is positioned on the substrate, a barrier layer that is positioned on the channel layer, a gate electrode that includes a first metal nitride layer which is positioned on the barrier layer, a second metal nitride layer which is positioned on the first metal nitride layer, and a first intermediate layer which is positioned between the first metal nitride layer and the second metal nitride layer, wherein the first metal nitride layer, the first intermediate layer, and the second metal nitride layer are stacked in a vertical direction perpendicular to an upper surface of the substrate, and a source electrode and a drain electrode that are connected to the channel layer and positioned on opposite sides of the gate electrode. An electrical resistivity of the first intermediate layer is higher than an electrical resistivity of each of the first metal nitride layer and the second metal nitride layer.

According to an aspect of the present disclosure, a semiconductor device includes a substrate, a buffer layer that is positioned on the substrate, a channel layer that is positioned on the buffer layer, a barrier layer that is positioned on the channel layer and contains a material having an energy band gap different from that of the channel layer, a gate electrode that is positioned on the barrier layer and extends in a first direction parallel with an upper surface of the substrate, a gate semiconductor layer that is positioned in a space between the barrier layer and the gate electrode, a protective layer that is positioned on the barrier layer and covers the gate electrode and the gate semiconductor layer, and a source electrode and a drain electrode that pass through the protective layer, and are connected to the channel layer. The source electrode and the drain electrode are positioned on opposite sides of the gate electrode, respectively. The gate electrode includes a first TiN layer which is positioned on the barrier layer, a second TiN layer which is positioned on the first TiN layer, and an AIN layer which is positioned in a space between the first TiN layer and the second TiN layer. An atom ratio of titanium to nitrogen of the second TiN layer is larger than an atomic ratio of titanium to nitrogen of the first TiN layer. A thickness of the AIN layer is larger than 0 nm and smaller than 3 nm.

According to an aspect of the present disclosure, a method of manufacturing a semiconductor device includes a step of forming a channel layer on a substrate, a step of forming a barrier layer on the channel layer, a step of forming a gate electrode on the barrier layer, and a step of forming a source electrode and a drain electrode on both sides of the gate electrode, respectively, so as to be connected to the channel layer, and the step of forming the gate electrode may include a step of forming a lower layer on the barrier layer and a step of forming an upper layer on the lower layer, and the lower layer and the upper layer may contain a metal nitride, and the atomic ratio of metal to nitrogen of the metal nitride contained in the upper layer may be larger than the atomic ratio of metal to nitrogen of the metal nitride contained in the lower layer.

In the method of manufacturing the semiconductor device according to the embodiment, the step of forming the gate electrode may further include a step of forming a first intermediate layer between the upper layer and the lower layer, and the first intermediate layer may contain a semiconductor material or an insulating material.

In the method of manufacturing the semiconductor device according to the embodiment, the resistivity of the semiconductor material or the insulating material contained in the first intermediate layer may be larger than the resistivity of the metal nitride contained in the upper layer and the lower layer.

In the method of manufacturing the semiconductor device according to the embodiment, the first intermediate layer may contain aluminum nitride (AIN).

In the method of manufacturing the semiconductor device according to the embodiment, the first intermediate layer may contain at least one of silicon oxide (SiO₂) and silicon nitride (SiN_{X}).

In the method of manufacturing the semiconductor device according to the embodiment, the step of forming the gate electrode may further include a step of forming a second intermediate layer between the upper layer and the lower layer, and the second intermediate layer may contain metal nitride, and the atomic ratio of metal to nitrogen of the metal nitride contained in the second intermediate layer may be smaller than the atomic ratio of metal to nitrogen of the metal nitride contained in the upper layer and larger than the atomic ratio of metal to nitrogen of the metal nitride contained in the lower layer.

In the method of manufacturing the semiconductor device according to the embodiment, the atomic ratio of metal to nitrogen of the metal nitride contained in the lower layer may gradually increase as it goes from the lower surface of the lower layer toward the upper surface of the lower layer.

In the method of manufacturing the semiconductor device according to the embodiment, the atomic ratio of metal to nitrogen of the metal nitride contained in the upper layer may gradually increase as it goes from the lower surface of the upper layer toward the upper surface of the upper layer.

According to one or more embodiments, it is possible to provide the semiconductor device with improved reliability.

At least some of the above and other features of the invention are set out in the claims.

### BRIEF DESCRIPTION OF THE DRAWINGS

FIG. 1 is a plan view illustrating a semiconductor device according to an embodiment.
FIGS. 2 and 3 are cross-sectional views illustrating the semiconductor device according to the embodiment.
FIG. 4 is an enlarged plan view of region A of FIG. 3.
FIGS. 5 to 8 are graphs illustrating the atomic ratio (M/N) of metal to nitrogen (N) of metal nitride of a gate electrode in the thickness direction.
FIG. 9 is a cross-sectional view illustrating a semiconductor device according to an embodiment.
FIG. 10 is a cross-sectional view illustrating a semiconductor device according to an embodiment.
FIG. 11 is a cross-sectional view illustrating a semiconductor device according to an embodiment.
FIG. 12 is a cross-sectional view illustrating a semiconductor device according to an embodiment.
FIG. 13 is a cross-sectional view illustrating a semiconductor device according to an embodiment.
FIGS. 14 to 20 are cross-sectional views illustrating processes of manufacturing a semiconductor device according to an embodiment in the order of the processes.

### DETAILED DESCRIPTION

In the following detailed description, only certain embodiments of the present disclosure have been shown and described, simply by way of illustration. The present disclosure can be variously implemented and is not limited to the following embodiments.

The drawings and description are to be regarded as illustrative in nature and not restrictive. Like reference numerals designate like elements throughout the specification.

In addition, the size and thickness of each configuration shown in the drawings are arbitrarily shown for understanding and ease of description, but the present disclosure is not limited thereto. In the drawings, the thicknesses of layers, films, panels, regions, etc., are exaggerated for clarity. Further, in the drawings, for understanding and ease of description, the thickness of some layers and areas is exaggerated.

Further, it will be understood that when an element such as a layer, film, region, or substrate is referred to as being "on" another element, it can be directly on the other element or intervening elements may also be present. In contrast, when an element is referred to as being "directly on" another element, there are no intervening elements present. Further, when an element is "on" a reference portion, the element is located above or below the reference portion, and it does not necessarily mean that the element is located "above" or "on" in a direction opposite to gravity.

In addition, in the entire specification, unless explicitly described to the contrary, the word "comprise", and variations such as "comprises" or "comprising", will be understood to imply the inclusion of stated elements but not the exclusion of any other elements.

Further, in the entire specification, when it is referred to as "on a plane", it means when a target part is viewed from above, and when it is referred to as "on a cross-section", it means when the cross-section obtained by cutting a target part vertically is viewed from the side.

Furthermore, in the entire specification, two directions parallel with the upper surface of a substrate and intersecting each other are defined as a first direction D1 and a second direction D2, and a direction perpendicular to the upper surface of the substrate will be described as a third direction D3. As an example, the first direction D1 and the second direction D2 may be orthogonal to each other.

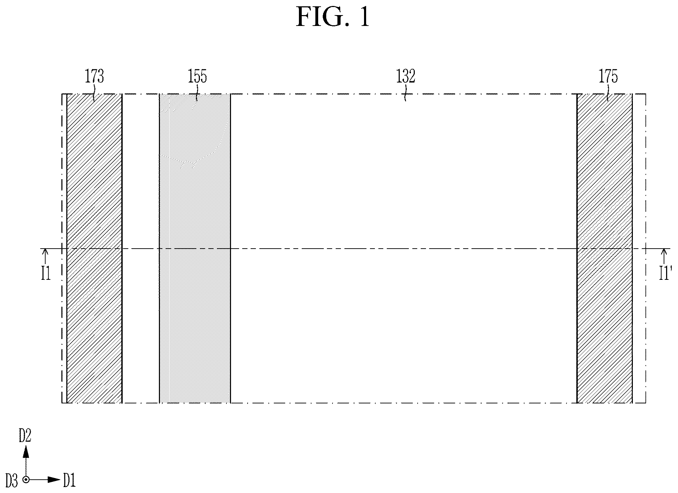

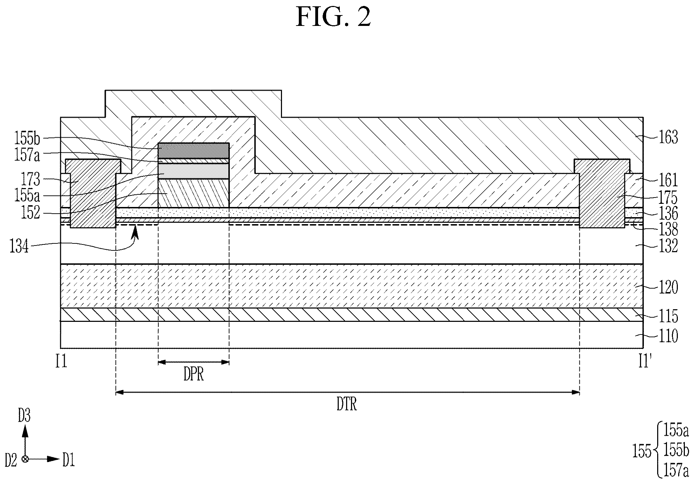

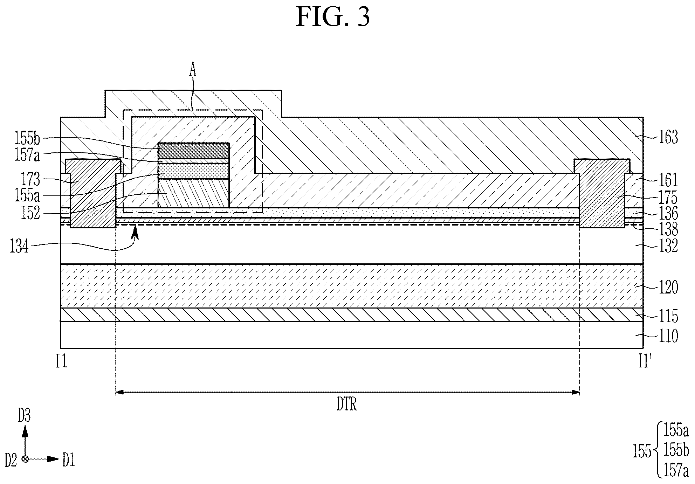

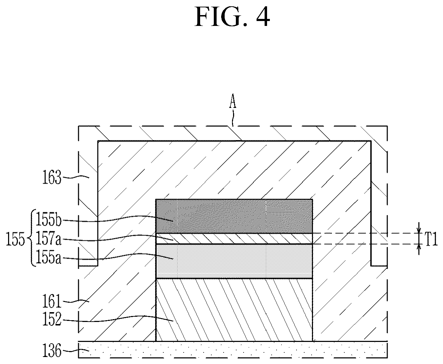

FIG. 1 is a plan view illustrating a semiconductor device according to an embodiment. FIGS. 2 to 3 are cross-sectional views taken along line I1-I1' of FIG. 1. FIG. 4 is an enlarged plan view of region A of FIG. 3.

For clear understanding and simple illustration, in FIG. 1, a channel layer 132, a gate electrode 155, a source electrode 173, and a drain electrode 175 are mainly shown.

Referring to FIGS. 1 to 4, a semiconductor device according to an embodiment may include a substrate 110, a channel layer 132 that is positioned on the substrate 110, a barrier layer 136 that is positioned on the channel layer 132, a gate electrode 155 that is positioned on the barrier layer 136, and a source electrode 173 and a drain electrode 175 that are positioned on opposite sides of the gate electrode 155.

The channel layer 132 may be a layer that forms a channel between the source electrode 173 and the drain electrode 175, and inside the channel layer 132, a 2-dimensional electron gas (2DEG) 134 may be positioned. The 2-dimensional electron gas 134 is a charge transfer model that is used in solid-state physics, and means a bunch of electrons that are tightly confined in two dimensions (for example, in a plane direction along the directions D1 and D2) such that they are free to migrate in the two dimensions but cannot migrate in the other dimension (for example, in the direction D3). In other words, the 2-dimensional electron gas 134 may exist in a form like a two-dimensional sheet in a three-dimensional space. Such 2-dimensional electron gases mainly appear in semiconductor heterojunction structures, and in the semiconductor device according to the embodiment, the 2-dimensional electron gas 134 may occur at the interface between the channel layer 132 and the barrier layer 136. For example, the 2-dimensional electron gas 134 may occur at a portion inside the channel layer 132 closest to the barrier layer 136.

The channel layer 132 may contain III-V materials, for example, nitrides containing Al, Ga, In, B, or a combination thereof. The channel layer 132 may consist of a single layer or multiple layers. As an example, the channel layer 132 may contain AlₓIn_{y}Ga_{1-x-y}N (wherein 0≤x≤1, 0≤y≤1, and x+y≤1), and for example, the channel layer 132 may contain AIN, GaN, InN, InGaN, AlGaN, AllnN, AllnGaN, or a combination thereof. The channel layer 132 may be a layer doped with impurities, or may be a layer undoped with impurities. The thickness of the channel layer 132 may be about hundreds of nm or less.

The channel layer 132 may be positioned on the substrate 110, and between the substrate 110 and the channel layer 132, a seed layer 115 or a buffer layer 120 may be positioned. The substrate 110, the seed layer 115, or the buffer layer 120 are layers for forming the channel layer 132, and may be omitted in some cases. For example, when a substrate made of GaN is used as the channel layer 132, at least one of the substrate 110, the seed layer 115, and the buffer layer 120 may be omitted. In consideration of the relatively high prices of substrates made of GaN, the substrate 110 made of Si may be used as a substrate to grow a channel layer 132 containing GaN. In this case, since the lattice structure of Si and the lattice structure of GaN are different, it may not be easy to grow the channel layer 132 directly on the substrate 110. Therefore, the seed layer 115 and the buffer layer 120 may be first grown on the substrate 110, and then the channel layer 132 may be grown on the buffer layer 120. Further, at least one of the substrate 110, the seed layer 115, and the buffer layer 120 may be removed from the final structure of the semiconductor device after being used in the manufacturing process.

The substrate 110 may contain a semiconductor material. For example, the substrate 110 may contain sapphire, Si, SiC, AIN, GaN, diamond, glass, or a combination thereof. The substrate 110 may be a silicon-on-insulator (SOI) substrate. However, the material of the substrate 110 is not limited thereto. In an embodiment, any substrate which is generally used may be applied. In some embodiments, the substrate 110 may contain an insulating material. For example, several layers including the channel layer 132 may be formed on a semiconductor substrate first, and then the semiconductor substrate may be removed and replaced with an insulating substrate.

The seed layer 115 may be positioned on the substrate 110. The seed layer 115 may be positioned directly on the substrate 110. However, the present disclosure is not limited thereto, and between the substrate 110 and the seed layer 115, other predetermined layers may be further positioned. The seed layer 115 is a layer to serve as a seed for epitaxially growing the buffer layer 120, and may be formed of a crystal lattice structure to be a seed for the buffer layer 120. For example, the seed layer 115 may contain AIN, but is not limited thereto.

The buffer layer 120 may be positioned on the seed layer 115. The buffer layer 120 may be positioned directly on the seed layer 115. However, the present disclosure is not limited thereto, and between the seed layer 115 and the buffer layer 120, other predetermined layers may be further positioned. The buffer layer 120 may be positioned between the seed layer 115 and the channel layer 132. The buffer layer 120 may contain III-V materials, for example, nitrides containing Al, Ga, In, B, or a combination thereof. As an example, the buffer layer 120 may contain AlₓIn_{y}Ga_{1-x-y}N (wherein 0≤x≤1, 0≤y≤1, and x+y≤1), and for example, the buffer layer 120 may contain AIN, GaN, InN, InGaN, AlGaN, AlInN, AlInGaN, or a combination thereof. The buffer layer 120 may consist of a single layer or multiple layers. For example, the buffer layer 120 may include a superlattice layer and a high-resistivity layer.

The superlattice layer is a layer for migrating differences in lattice constant and thermal expansion coefficient between the substrate 110 and the channel layer 132, thereby relieving tensile stress and compressive stress that is generated between the substrate 110 and the channel layer 132.

The high-resistivity layer may be positioned on the superlattice layer. For example, the high-resistivity layer may be positioned directly on the superlattice layer. However, the present disclosure is not limited thereto, and between the superlattice layer and the high-resistivity layer, other layers may be further positioned. The high-resistivity layer may be positioned between the superlattice layer and the channel layer 132. The high-resistivity layer is a layer for preventing leakage current from flowing through the channel layer 132, thereby preventing the semiconductor device from being deteriorated. The high-resistivity layer may consist of a material having low conductivity such that the substrate 110 and the channel layer 132 can be electrically insulated from each other.

As an example, the high-resistivity layer may have a resistance value equal to or larger than 1.0×10⁶ Ω·cm. For example, the resistance value of the high-resistivity layer may be equal to or larger than 1.0×10¹⁰ Ω·cm. As another example, the resistance value of the high-resistivity layer may be equal to or larger than 1.0×10¹² Ω·cm. The resistance value may be measured by forming a conductive measurement electrode inside the high-resistivity layer.

The high-resistivity layer may contain III-V materials, for example, nitrides containing Al, Ga, In, B, or a combination thereof. As an example, the high-resistivity layer may contain AlₓIn_{y}Ga_{1-x-y}N (wherein 0≤x≤1, 0≤y≤1, and x+y≤1), for example, AIN, GaN, InN, InGaN, AlGaN, AlInN, AllnGaN, or a combination thereof. The high-resistivity layer may consist of a single layer or multiple layers.

The barrier layer 136 may be positioned on the channel layer 132. The barrier layer 136 may be positioned directly on the channel layer 132. However, the present disclosure is not limited thereto, and between the channel layer 132 and the barrier layer 136, other predetermined layers may be further positioned. A region of the channel layer 132 overlapping the barrier layer 136 may be referred to as a drift region DTR. The drift region DTR may be positioned between the source electrode 173 and the drain electrode 175. When a potential difference occurs between the source electrode 173 and the drain electrode 175, carriers may migrate in the drift region DTR. The semiconductor device may be turned on and off according to whether voltage is applied to the gate electrode 155 and the magnitude of voltage which is applied to the gate electrode 155. The transistor as shown in FIG. 2 is an enhancement-mode transistor. For example, a semiconductor layer 152 disposed between the gate electrode 155 and the barrier layer 136 has a built-in electric field, which cancels the polarization field formed at the interface between the barrier layer 136 and the channel layer 132, thereby forming a depletion region DPR under the gate electrode 155. In an embodiment, when the barrier layer 136 is formed of AlGaN and the channel layer 132 is formed of GaN, the channel layer 132 may have the 2DEG 134 at a region adjacent to the interface between the channel layer 132 and the barrier layer 136 due to polarization effects without doping. The 2DEG 134 serves as a high-mobility channel that enables fast switching and high current density. In an embodiment, to form an enhancement-mode transistor, a semiconductor layer 152 which is formed of a p-type doped GaN is formed in a space between the gate electrode 155 and the barrier layer 136, thereby forming the depletion region DPR. When a voltage equal to or higher than a threshold voltage is applied to the gate electrode 155 such that the semiconductor device is turned on, a channel may be generated in the depletion region DPR under the gate electrode 155. Accordingly, in the drift region DTR, migration of carriers may be enabled. When a voltage lower than the threshold voltage or no voltage is applied to the gate electrode 155, in the depletion region DPR, the channel path may be blocked, or migration of carriers may not be enabled.

The barrier layer 136 may contain III-V materials, for example, nitrides containing Al, Ga, In, B, or a combination thereof. As an example, the barrier layer 136 may contain AlₓIn_{y}Ga_{1-x-y}N (wherein 0≤x≤1, 0≤y≤1, and x+y≤1), and for example, the barrier layer 136 may contain GaN, InN, AlGaN, AllnN, InGaN, AIN, AllnGaN, or a combination thereof. The energy band gap of the barrier layer 136 may be adjusted by the composition ratio of Al or In.

The barrier layer 136 may contain a semiconductor material having different characteristics from those of the channel layer 132. At least one of the polarization characteristics, energy band gap, and lattice constant of the barrier layer 136 may be different from that of the channel layer 132. For example, the barrier layer 136 may contain a material having an energy band gap different from that of the channel layer 132. In this case, the barrier layer 136 may have an energy band gap higher than that of the channel layer 132, and may have electrical polarizability higher than that of the channel layer 132. By this barrier layer 136, the 2-dimensional electron gas 134 may be induced in the channel layer 132 having relatively low electrical polarizability. In this regard, the barrier layer 136 may be referred to as a channel supply layer or a 2-dimensional electron gas supply layer. The 2-dimensional electron gas 134 may be formed in a portion of the channel layer 132 positioned below the interface between the channel layer 132 and the barrier layer 136. The 2-dimensional electron gas 134 may have very high electron mobility.

The semiconductor device according to the embodiment may further include a spacer layer 138 which is positioned between the barrier layer 136 and the channel layer 132. The upper surface and lower surface of the spacer layer 138 may abut the lower surface of the barrier layer 136 and the channel layer 132, respectively. The width of the spacer layer 138 in the first direction D1 and the second direction D2 may be substantially the same as the widths of the channel layer 132 and the barrier layer 136 in the first direction D1 or the second direction D2.

The spacer layer 138 may contain III-V materials, for example, one or more materials selected from nitrides containing at least one material of Al, Ga, or In. The spacer layer 138 may be formed of AlₓIn_{y}Ga_{1-x-y}N (wherein 0≤x≤1, 0≤y≤1, and x+y≤1). For example, the spacer layer 138 may contain at least one of AIN, GaN, InN, InGaN, AlGaN, AllnN, and AllnGaN.

In the embodiment, the spacer layer 138 may contain a material having an energy band gap different from those of the channel layer 132 and the barrier layer 136. For example, the spacer layer 138 may contain a material having an energy band gap larger than the energy band gaps of the materials contained in the channel layer 132 and the barrier layer 136. For example, the channel layer 132 may contain GaN, and when the barrier layer 136 contains AlGaN, the spacer layer 138 may contain AIN. In the semiconductor device according to the embodiment, the spacer layer 138 may be omitted. In this case, the lower surface of the barrier layer 136 and the upper surface of the channel layer 132 may abut each other.

When the spacer layer 138 containing a material having an energy band gap larger than that of the barrier layer 136 is positioned between the channel layer 132 and the barrier layer 136, the density of the 2-dimensional electron gas 134 which is formed inside the channel layer 132 may become higher as compared to the case where the spacer layer 138 is not positioned. Accordingly, as compared to the case where the spacer layer 138 is not positioned, the electrical characteristics of the semiconductor device according to the embodiment may be improved.

In the embodiment, the spacer layer 138 may be significantly thinner than the channel layer 132 and the barrier layer 136. When the spacer layer 138 is excessively thick, the crystallinity of the barrier layer 136 which is formed on the spacer layer 138 may be reduced due to a difference in lattice constant between the material contained in the spacer layer 138 (for example, AIN) and the material contained in the barrier layer 136 (for example, AlGaN). For this reason, the spacer layer 138 may have a very small thickness compared to the thicknesses of the channel layer 132 and the barrier layer 136. For example, the thickness of the spacer layer 138 may be equal to or smaller than about 1 nm. Terms such as "about" or "approximately" may reflect amounts, sizes, orientations, or layouts that vary only in a small relative manner, and/or in a way that does not significantly alter the operation, functionality, or structure of certain elements. For example, a range from "about 0.1 to about 1" may encompass a range such as a 0%-5% deviation around 0.1 and a 0% to 5% deviation around 1, especially if such deviation maintains the same effect as the listed range.

The semiconductor device according to the embodiment may further include a gate semiconductor layer 152 which is positioned on the barrier layer 136. The gate semiconductor layer 152 may be positioned between the barrier layer 136 and the gate electrode 155. In other words, the gate semiconductor layer 152 may be positioned on the barrier layer 136, and the gate electrode 155 may be positioned on the gate semiconductor layer 152. In the embodiment, the gate semiconductor layer 152 may form a Schottky contact with the gate electrode 155 to be described below. The gate semiconductor layer 152 may overlap the gate electrode 155 in the third direction D3. The upper surface of the gate semiconductor layer 152 may be entirely covered by the gate electrode 155.

The gate semiconductor layer 152 may be positioned between the source electrode 173 and the drain electrode 175 in the second direction D2. The gate semiconductor layer 152 may be spaced apart from the source electrode 173 and the drain electrode 175 in the second direction D2. The gate semiconductor layer 152 may be positioned closer to the source electrode 173 than to the drain electrode 175. In other words, the separation distance between the gate semiconductor layer 152 and the source electrode 173 may be smaller than the separation distance between the gate semiconductor layer 152 and the drain electrode 175.

The gate semiconductor layer 152 may contain III-V materials, for example, nitrides containing Al, Ga, In, B, or a combination thereof. The gate semiconductor layer 152 may contain AlₓIn_{y}Ga_{1-x-y}N (wherein 0≤x≤1, 0≤y≤1, and x+y≤1). For example, the gate semiconductor layer 152 may contain AIN, GaN, InN, InGaN, AlGaN, AllnN, AllnGaN, or a combination thereof. The gate semiconductor layer 152 may contain a material having an energy band gap different from that of the barrier layer 136. For example, the gate semiconductor layer 152 may contain GaN, and the barrier layer 136 may contain AlGaN. The gate semiconductor layer 152 may be doped with a predetermined impurity. In an embodiment, the gate semiconductor layer 152 may be doped with a p-type dopant capable of providing holes. For example, the gate semiconductor layer 152 may contain GaN doped with a p-type impurity. In other words, the gate semiconductor layer 152 may consist of a p-type doped GaN layer. However, the gate semiconductor layer 152 is not limited thereto, and may be a p-type doped AlGaN layer. In an embodiment, the gate semiconductor layer 152 may be doped with magnesium (Mg). The gate semiconductor layer 152 may consist of a single layer or multiple layers.

By the gate semiconductor layer 152, a depletion region DPR may be formed inside the channel layer 132. The depletion region DPR may be positioned inside the drift region DTR, and may have a width smaller than that of the drift region DTR. As the gate semiconductor layer 152 having an energy band gap different from that of the barrier layer 136 is positioned on the barrier layer 136, the level of the energy band of a portion of the barrier layer 136 overlapping the gate semiconductor layer 152 may be raised. Accordingly, the depletion region DPR may be formed in the region of the channel layer 132 overlapping the gate semiconductor layer 152. The depletion region DPR may be a region on the channel path of the channel layer 132 where the 2-dimensional electron gas 134 is not formed or which has an electron concentration lower than that of the other regions of the 2-dimensional electron gas 134. In other words, the depletion region DPR may refer to a region in the drift region DTR where the flow of the 2-dimensional electron gas 134 is cut off. As the depletion region DPR is generated, when no voltage (i.e., a voltage lower than the threshold voltage) is applied to the gate electrode 155, no current may flow between the source electrode 173 and the drain electrode 175, and the channel path may be blocked. Accordingly, the semiconductor device may have a normally-off characteristic, and may be an enhancement-mode transistor.

The gate electrode 155 may be positioned on the barrier layer 136. The gate electrode 155 may overlap a partial region of the barrier layer 136 in the third direction D3. The gate electrode 155 may overlap a portion of the drift region DTR of the channel layer 132 in the third direction D3. The gate electrode 155 may be positioned between the source electrode 173 and the drain electrode 175 in the second direction D2. The gate electrode 155 may be spaced apart from the source electrode 173 and the drain electrode 175 in the second direction D2. The gate electrode 155 may extend in the first direction D1 in a plan view. In other words, the gate electrode 155 may have a bar shape extending along the first direction D1 in a plan view. The dimension in the first direction D1 of the gate electrode 155 may determine a channel length of a transistor having the gate electrode 155. The gate electrode 155 may extend in the second direction D2, and a dimension in the second direction D2 of the gate electrode may determine a channel width of the transistor.

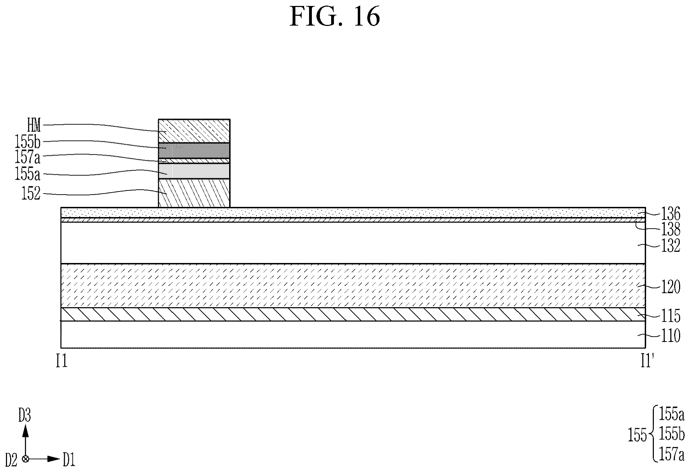

In the embodiment, the gate electrode 155 may include a plurality of layers. Referring to FIGS. 2 and 3, the gate electrode 155 may include a lower layer 155a, a first intermediate layer 157a, and an upper layer 155b sequentially stacked on the upper surface of the gate semiconductor layer 152 in the third direction D3. In the embodiment, the lower layer 155a may be positioned on the upper surface of the gate semiconductor layer 152, and the first intermediate layer 157a may be positioned on the upper surface of the lower layer 155a, and the upper layer 155b may be positioned on the upper surface of the first intermediate layer 157a. In the embodiment, the widths of the lower layer 155a, the first intermediate layer 157a, and the upper layer 155b in the first direction D1 or the second direction D2 may be substantially the same. This may be due to a process characteristic in which in the process of forming the gate electrode 155, the lower layer 155a, the first intermediate layer 157a, and the upper layer 155b are formed simultaneously in the same process by etching using the same hard mask HM (see FIG. 16).

Unlike in FIGS. 1 to 4, between the lower layer 155a and the first intermediate layer 157a or between the first intermediate layer 157a and the upper layer 155b, at least one other layer may be interposed.

Referring to FIG. 4, in the embodiment, the thickness T1 of the first intermediate layer 157a in the third direction D3 may be significantly smaller than the thicknesses of the lower layer 155a and the upper layer 155b in the third direction D3. In the embodiment, the thickness of the first intermediate layer 157a in the third direction D3 may be sufficiently small to allow charge to flow through the first intermediate layer 157a in the third direction D3 by tunneling during the operation of the semiconductor device according to the embodiment. As an example, the thickness of the first intermediate layer 157a in the third direction D3 is larger than 0 and equal to or smaller than about 3 nm.

The gate electrode 155 may contain a conductive metal nitride. In an embodiment, the gate electrode 155 may include the upper layer 155b which is a conductive metal nitride layer and the lower layer 155a which is a conductive metal nitride layer. In an embodiment, the conductive metal nitride layer of the upper layer 155b and the conductive metal nitride layer of the lower layer 155a may have different atomic ratios of metal to nitrogen. Examples of the metal of the conductive metal nitride may include tungsten (W), aluminum (Al), copper (Cu), cobalt (Co), titanium (Ti), tantalum (Ta), nickel (Ni), platinum (Pt), nickel-platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), ruthenium (Ru), iridium (Ir), osmium (Os), silver (Ag), gold (Au), zinc (Zn), vanadium (V), or a combination thereof. For example, the gate electrode 155 may contain a metal nitride (i.e., a conductive metal nitride) containing titanium nitride (TiN), titanium silicon nitride (TiSiN), tantalum nitride (TaN), tantalum silicon nitride (TaSiN), tantalum titanium nitride (TaTiN), titanium aluminum nitride (TiAIN), tantalum aluminum nitride (TaAlN), tungsten nitride (WN), titanium aluminum carbonitride (TiAIC-N), or a combination thereof.

In the embodiment, in order to control the work function and resistivity of the gate electrode 155, the atomic ratio of metal to nitrogen (N) of the metal nitride contained in the gate electrode 155 may be controlled (this will be described below). Here, when the metal nitride contains a plurality of metals, such as titanium silicon nitride (TiSiN), tantalum silicon nitride (TaSiN), tantalum titanium nitride (TaTiN), titanium aluminum nitride (TiAIN), tantalum aluminum nitride (TaAIN), and titanium aluminum carbonitride (TiAIC-N), in the atomic ratio (M/N) of metal to nitrogen (N) of the metal nitride, the content of the metal may be the sum of the contents of the plurality of metals. For example, the atomic ratio (M/N) of metal to nitrogen (N) of titanium silicon nitride (TiSiN) may be the atomic ratio (N/(Ti+Si)) of nitrogen (N) to titanium and silicon (Ti+Si). The atomic ratio of a compound refers to the proportional number of at least one non-nitrogen element present in that compound and a number of nitrogen atoms. For example, when the metal nitride is TiSiN, the non-nitrogen elements are Ti and Si, and the atomic ratio of TiSiN corresponds to a ratio of a sum of a number of Ti atoms and a number of Si atoms to a number of nitrogen atoms.

In the embodiment, at the interface between the gate electrode 155 and the gate semiconductor layer 152, a Schottky contact may be formed. In the semiconductor device according to the embodiment, as the gate electrode 155 and the gate semiconductor layer 152 form a Schottky contact, gate leakage current which flows from the channel layer 132 to the gate electrode 155 through the gate semiconductor layer 152 can be reduced, and the 2-dimensional electron gas 134 which is formed in the channel layer 132 below the gate semiconductor layer 152 can be stably controlled.

In order to form a Schottky contact at the interface between the gate electrode 155 and the gate semiconductor layer 152, the lower layer 155a included in the gate electrode 155 may be controlled so as to have a predetermined work function value. For example, in the case where the gate semiconductor layer 152 contains GaN, for example, a p-type doped GaN, and the lower layer 155a of the gate electrode 155 contains titanium nitride (TiN), when the work function value of titanium nitride (TiN) contained in the lower layer 155a is about 4.3 eV to about 4.7 eV, the gate electrode 155 and the gate semiconductor layer 152 may form a Schottky contact.

In the embodiment, the work function of the metal nitride may be adjusted by controlling the ratio of metal and nitrogen contained in the metal nitride. As an example, the work function of titanium nitride (TiN) may be adjusted by controlling the ratio of titanium (Ti) and nitrogen (N) contained in titanium nitride (TiN). In the embodiment, the lower layer 155a of the gate electrode 155 may contain titanium nitride (TiN), and the ratio of titanium (Ti) to nitrogen (N) of titanium nitride (TiN) contained in the lower layer 155a may be larger than or equal to about 0.7 and smaller than or equal to about 1.0. In this case, titanium nitride (TiN) contained in the lower layer 155a may have a work function of about 4.3 eV to about 4.7 eV, and accordingly, a Schottky contact may be stably formed at the interface between the gate electrode 155 and the gate semiconductor layer 152.

In the embodiment, the upper layer 155b may be controlled so as to have higher resistivity than the lower layer 155a. In the embodiment, the semiconductor device may be exposed to an overvoltage or overcurrent condition for a short time, and in this case, the semiconductor device may be damaged by electrical overstress (EOS). In the embodiment, the upper layer 155b included in the gate electrode 155 may be controlled so as to have relatively high resistivity, and accordingly, the influence of EOS that may occur around the gate electrode 155 can be minimized.

In the embodiment, the resistivity of the metal nitride may be adjusted by controlling the ratio of metal and nitrogen contained in the metal nitride. As an example, the resistivity of titanium nitride (TiN) may be adjusted by controlling the ratio of titanium (Ti) and nitrogen (N) contained in titanium nitride (TiN). In the embodiment, the resistivity (i.e., the electrical resistivity) of titanium nitride (TiN) may increase as the ratio of titanium (Ti) to nitrogen (N) contained in titanium nitride (TiN) increases. For example, when the atomic ratio of titanium (Ti) to nitrogen (N) exceeds 1, the resistivity of titanium nitride (TiN) may become lower as the ratio approaches the stoichiometric composition of 1:1. In the embodiment, the upper layer 155b of the gate electrode 155 may contain titanium nitride (TiN), and the ratio of titanium (Ti) to nitrogen (N) of the titanium nitride (TiN) contained in the upper layer 155b may be higher than the ratio of titanium (Ti) to nitrogen (N) of titanium nitride (TiN) contained in the lower layer 155a. For example, the ratio of titanium (Ti) to nitrogen (N) of titanium nitride (TiN) contained in the upper layer 155b may be larger than or equal to about 1.1 and smaller than or equal to about 1.4. In this case, the upper layer 155b may have relatively higher resistivity than the lower layer 155a, and accordingly, the influence of EOS can be minimized during the operation of the semiconductor device according to the embodiment. The reliability of the semiconductor device can be improved.

The first intermediate layer 157a may contain an insulating material or a semiconductor material. In the embodiment, the first intermediate layer 157a may contain a material having higher resistivity than the lower layer 155a and the upper layer 155b.

In some embodiments, the first intermediate layer 157a may contain silicon oxide (SiO₂) or silicon nitride (SiN_{X}). When the first intermediate layer 157a contains silicon oxide (SiO₂) or silicon nitride (SiN_{X}), the first intermediate layer 157a may have higher resistivity than the lower layer 155a and the upper layer 155b, and accordingly, the influence of EOS around the gate electrode 155 of the semiconductor device according to the embodiment can be minimized. The reliability of the semiconductor device can be improved.

In some embodiments, the first intermediate layer 157a may contain a III-V compound semiconductor material. For example, the first intermediate layer 157a may contain aluminum nitride (AIN). Aluminum nitride (AIN) may have higher resistivity than the metal nitrides contained in the lower layer 155a and the upper layer 155b (for example, titanium nitride (TiN)). Aluminum nitride (AIN) may have higher thermal conductivity than the metal nitrides contained in the lower layer 155a and the upper layer 155b (for example, titanium nitride (TiN)). Accordingly, the influence of EOS around the gate electrode 155 of the semiconductor device according to the embodiment can be minimized, and heat which may be generated at the gate electrode 155 during the operation of the semiconductor device can be effectively consumed, whereby the durability and life of the semiconductor device according to the embodiment can be improved.

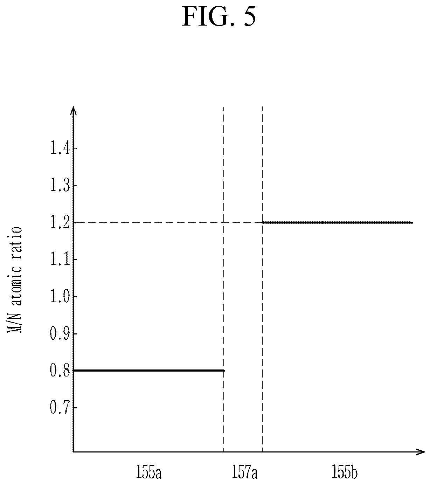

Hereinafter, referring to FIGS. 5 to 8, the atomic ratio (M/N) of metal to nitrogen of the metal nitride, contained in the gate electrode 155 of the semiconductor device according to the embodiment, in the thickness direction (for example, the third direction D3) will be described. In FIGS. 5 to 8, the x axis may represent the distance from the lower surface of the lower layer 155a to the upper surface of the upper layer 155b in the third direction D3, and the y axis may represent the atomic ratio (M/N) of metal to nitrogen of the metal nitride contained in the gate electrode 155.

First, referring to FIG. 5, in each of the lower layer 155a and the upper layer 155b, the atomic ratio (M/N) of metal to nitrogen of the metal nitride may be a constant value along the third direction D3. In this case, the atomic ratio (M/N) of metal to nitrogen in the upper layer 155b may be a value larger than the atomic ratio (M/N) of metal to nitrogen in the lower layer 155a. In an embodiment, the lower layer 155a may correspond to a first metal nitride layer, and an atomic ratio of metal to nitrogen of a metal nitride of the first metal nitride layer has a first atomic ratio. The upper layer 155b may correspond to a second metal nitride layer, and an atomic ratio of metal to nitrogen of a metal nitride of the second metal nitride layer has a second atomic ratio. The second atomic ratio is greater than the first atomic ratio.

Referring to FIG. 5, it is shown that in the lower layer 155a, the atomic ratio (M/N) of metal to nitrogen is 0.8; however, this is an example. For example, in the lower layer 155a, the atomic ratio (M/N) of metal to nitrogen may have various values between about 0.7 and about 1.0. For example, in the lower layer 155a, the atomic ratio (M/N) of metal to nitrogen may be one value of 0.7, 0.9, and 1.0. For example, in the lower layer 155a, the atomic ratio (M/N) of metal to nitrogen may be one of 0.75, 0.85, and 0.95.

Referring to FIG. 5, it is shown that in the upper layer 155b, the atomic ratio (M/N) of metal to nitrogen is 1.2; however, this is an example. For example, in the upper layer 155b, the atomic ratio (M/N) of metal to nitrogen may have various values between about 1.1 and about 1.4. For example, in the upper layer 155b, the atomic ratio (M/N) of metal to nitrogen may be one value of 1.1, 1.3, and 1.4. For example, in the upper layer 155b, the atomic ratio (M/N) of metal to nitrogen may be one value of 1.15, 1.25, and 1.35.

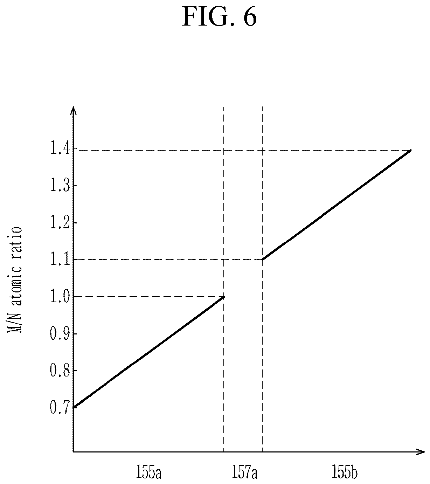

Referring to FIG. 6, in each of the lower layer 155a and the upper layer 155b, the atomic ratio (M/N) of metal to nitrogen of the metal nitride may have values which linearly increase along the third direction D3. In this case, the minimum value of the atomic ratio (M/N) of metal to nitrogen in the upper layer 155b may be a value larger than the maximum value of the atomic ratio (M/N) of metal to nitrogen in the lower layer 155a.

Referring to FIG. 6, the atomic ratio (M/N) of metal to nitrogen at the lower surface of the lower layer 155a may be 0.7, and the atomic ratio (M/N) of metal to nitrogen at the upper surface of the lower layer 155a may be 1.0. The atomic ratio (M/N) of metal to nitrogen in the lower layer 155a may linearly increase from 0.7 to 1.0 along the third direction D3. However, this is an example of the atomic ratio (M/N) of metal to nitrogen along the third direction D3 in the lower layer 155a. For example, in the lower layer 155a, the atomic ratio (M/N) of metal to nitrogen along the third direction D3 may have various values between 0.7 and 1.0, and may increase at various gradients.

For example, the atomic ratio (M/N) of metal to nitrogen at the lower surface of the lower layer 155a may be 0.7, and the atomic ratio (M/N) of metal to nitrogen at the upper surface of the lower layer 155a may be 0.9, and the atomic ratio (M/N) of metal to nitrogen in the lower layer 155a may linearly increase from 0.7 to 0.9 along the third direction D3. As another example, the atomic ratio (M/N) of metal to nitrogen at the lower surface of the lower layer 155a may be 0.7, and the atomic ratio (M/N) of metal to nitrogen at the upper surface of the lower layer 155a may be 0.8, and the atomic ratio (M/N) of metal to nitrogen in the lower layer 155a may linearly increase from 0.7 to 0.8 along the third direction D3.

For example, the atomic ratio (M/N) of metal to nitrogen at the lower surface of the lower layer 155a may be 0.8, and the atomic ratio (M/N) of metal to nitrogen at the upper surface of the lower layer 155a may be 1.0, and the atomic ratio (M/N) of metal to nitrogen in the lower layer 155a may linearly increase from 0.8 to 1.0 along the third direction D3. As another example, the atomic ratio (M/N) of metal to nitrogen at the lower surface of the lower layer 155a may be 0.8, and the atomic ratio (M/N) of metal to nitrogen at the upper surface of the lower layer 155a may be 0.9, and the atomic ratio (M/N) of metal to nitrogen in the lower layer 155a may linearly increase from 0.8 to 0.9 along the third direction.

For example, the atomic ratio (M/N) of metal to nitrogen at the lower surface of the lower layer 155a may be 0.9, and the atomic ratio (M/N) of metal to nitrogen at the upper surface of the lower layer 155a may be 1.0, and the atomic ratio (M/N) of metal to nitrogen in the lower layer 155a may linearly increase from 0.9 to 1.0 along the third direction D3. Various other embodiments are possible.

Referring to FIG. 6, the atomic ratio (M/N) of metal to nitrogen at the lower surface of the upper layer 155b may be 1.1, and the atomic ratio (M/N) of metal to nitrogen at the upper surface of the upper layer 155b may be 1.4. The atomic ratio (M/N) of metal to nitrogen in the upper layer 155b may linearly increase from 1.1 to 1.4 along the third direction D3. However, this is an example of the atomic ratio (M/N) of metal to nitrogen along the third direction D3 in the upper layer 155b. For example, in the upper layer 155b, the atomic ratio (M/N) of metal to nitrogen along the third direction D3 may have various values between 1.1 and 1.4, and may increase at various gradients. A specific example of this is similar to the example of the atomic ratio (M/N) of metal to nitrogen in the lower layer 155a, and thus, a description thereof will not be made.

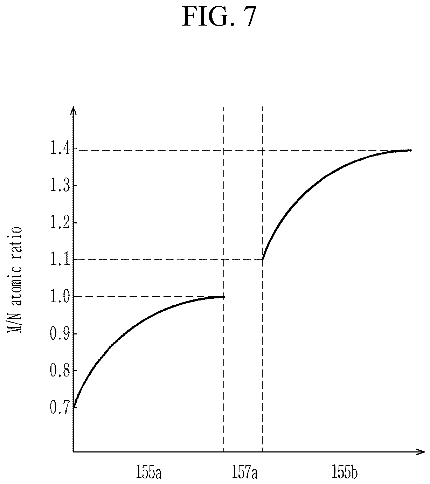

Referring to FIG. 7, in each of the lower layer 155a and the upper layer 155b, the atomic ratio (M/N) of metal to nitrogen of the metal nitride may gradually increase along the third direction D3, and in this case, the rate of increase may gradually decrease. In the embodiment, the minimum value of the atomic ratio (M/N) of metal to nitrogen in the upper layer 155b may be a value larger than the maximum value of the atomic ratio (M/N) of metal to nitrogen in the lower layer 155a.

Referring to FIG. 7, the atomic ratio (M/N) of metal to nitrogen at the lower surface of the lower layer 155a may be 0.7, and the atomic ratio (M/N) of metal to nitrogen at the upper surface of the lower layer 155a may be 1.0. The atomic ratio (M/N) of metal to nitrogen in the lower layer 155a may increase from 0.7 to 1.0 along the third direction D3, and the rate of increase may gradually decrease along the third direction D3. In the lower layer 155a, the atomic ratio (M/N) of metal to nitrogen along the third direction D3 may have various values between 0.7 and 1.0, and may increase at various gradients along the third direction D3, and in this case, the rate of increase may gradually decrease along the third direction D3.

Referring to FIG. 7, the atomic ratio (M/N) of metal to nitrogen at the lower surface of the upper layer 155b may be 1.1, and the atomic ratio (M/N) of metal to nitrogen at the upper surface of the upper layer 155b may be 1.4. The atomic ratio (M/N) of metal to nitrogen in the upper layer 155b may increase from 1.1 to 1.4 along the third direction D3, and the rate of increase may gradually decrease along the third direction D3. In the upper layer 155b, the atomic ratio (M/N) of metal to nitrogen along the third direction D3 may have various values between 1.1 and 1.4, and may increase at various gradients along the third direction D3, and in this case, the rate of increase may gradually decrease along the third direction D3.

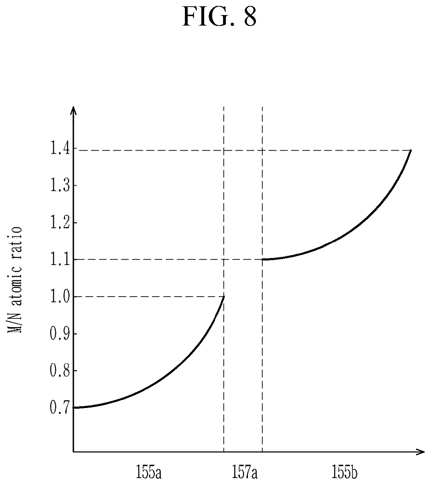

Referring to FIG. 8, in each of the lower layer 155a and the upper layer 155b, the atomic ratio (M/N) of metal to nitrogen of the metal nitride may gradually increase along the third direction D3, and in this case, the rate of increase may gradually increase along the third direction D3. In the embodiment, the minimum value of the atomic ratio (M/N) of metal to nitrogen in the upper layer 155b may be a value larger than the maximum value of the atomic ratio (M/N) of metal to nitrogen in the lower layer 155a.

Referring to FIG. 8, the atomic ratio (M/N) of metal to nitrogen at the lower surface of the lower layer 155a may be 0.7, and the atomic ratio (M/N) of metal to nitrogen at the upper surface of the lower layer 155a may be 1.0. The atomic ratio (M/N) of metal to nitrogen in the lower layer 155a may increase from 0.7 to 1.0 along the third direction D3, and the rate of increase may gradually increase along the third direction D3. In the lower layer 155a, the atomic ratio (M/N) of metal to nitrogen along the third direction D3 may have various values between 0.7 and 1.0, and may increase at various gradients along the third direction D3, and in this case, the rate of increase may gradually increase along the third direction D3.

Referring to FIG. 8, the atomic ratio (M/N) of metal to nitrogen at the lower surface of the upper layer 155b may be 1.1, and the atomic ratio (M/N) of metal to nitrogen at the upper surface of the upper layer 155b may be 1.4. The atomic ratio (M/N) of metal to nitrogen in the upper layer 155b may increase from 1.1 to 1.4 along the third direction D3, and the rate of increase may gradually increase along the third direction D3. In the upper layer 155b, the atomic ratio (M/N) of metal to nitrogen along the third direction D3 may have various values between 1.1 and 1.4, and may increase at various gradients along the third direction D3, and in this case, the rate of increase may gradually increase along the third direction D3.

In the embodiment, the semiconductor device may be a normally-off high electron mobility transistor (HEMT)(i.e., an enhancement-mode HEMT). In a normal state in which voltage is not applied to the gate electrode 155, the depletion region DPR may exist, and the semiconductor device may be off. When a voltage equal to or higher than a threshold voltage is applied to the gate electrode 155, the depletion region DPR may disappear (i.e., a channel is formed in the depletion region DPR), and the channel under the gate electrode 155 is connected to the 2-dimensional electron gas 134, thereby forming a continuous channel inside the drift region DTR. In other words, the 2-dimensional electron gas 134 may be formed over the entire channel path between the source electrode 173 and the drain electrode 175, and the semiconductor device may be turned on. In summary, the semiconductor device may include semiconductor layers having different electrical polarization characteristics, and a semiconductor layer having relatively high polarizability may cause the 2-dimensional electron gas 134 in another semiconductor layer forming a heterojunction with it. This 2-dimensional electron gas 134 may be used as a channel between the source electrode 173 and the drain electrode 175, and the interruption of the flow of the 2-dimensional electron gas 134 may be formed by a semiconductor layer disposed in a space between the barrier layer and the gate electrode. The control of the continuation of the 2-dimensional electron gas 134 between the source electrode and the drain electrode may be controlled by a bias voltage that is applied to the gate electrode 155. In the gate-off state, the flow of the 2-dimensional electron gas 134 may be blocked, and no current flows between the source electrode 173 and the drain electrode 175. In the gate-on state, as the flow of the 2-dimensional electron gas 134 continues, current may flow between the source electrode 173 and the drain electrode 175.

Although it has been described above that the semiconductor device is a normally-off high electron mobility transistor (i.e., an enhancement-mode transistor), the present disclosure is not limited thereto. For example, the semiconductor device may be a normally-on high electron mobility transistor (i.e., a depletion mode transistor). When the semiconductor device is a normally-on high electron mobility transistor, the gate semiconductor layer 152 may be omitted, whereby the gate electrode 155 may be positioned directly on the barrier layer 136. In other words, the gate electrode 155 may abut the barrier layer 136. However, the present disclosure is not limited thereto, and between the gate electrode 155 and the barrier layer 136, a gate insulating layer may be interposed. In this structure, in a state where no voltage is applied to the gate electrode 155, the 2-dimensional electron gas 134 may be used as a channel, and a flow of current may occur between the source electrode 173 and the drain electrode 175. Further, when a negative voltage is applied to the gate electrode 155, a depletion region where the flow of the 2-dimensional electron gas 134 is cut off may occur under the gate electrode 155.

Referring to FIGS. 1 to 4, the semiconductor device according to the embodiment may further include protective layers 161 and 163 which are positioned on the barrier layer 136 and the gate electrode 155. As an example, the semiconductor device according to the embodiment may further include a first protective layer 161, and a second protective layer 163 that is positioned on the first protective layer 161.

The first protective layer 161 may cover the upper surfaces of the barrier layer 136 and the gate electrode 155, and may cover the side surface of the gate electrode 155 and the side surface of the gate semiconductor layer 152. The lower surface of the first protective layer 161 may abut the barrier layer 136, the gate electrode 155, and the gate semiconductor layer 152. The upper surface of the first protective layer 161 may abut the second protective layer 163.

The barrier layer 136 and the gate electrode 155 may be protected and separated from other constituent elements by the protective layers 161 and 163. The protective layers 161 and 163 may contain an insulating material. For example, the protective layers 161 and 163 may contain an oxide such as SiO₂ and Al₂O₃. As another example, the protective layers 161 and 163 may contain a nitride such as SiN and an oxynitride such as SiON. The protective layers 161 and 163 may contain the same material, or may contain different materials. When the protective layers 161 and 163 consist of the same material, the boundary between the protective layers 161 and 163 may not be visible. Each of the protective layers 161 and 163 may consist of a single layer or multiple layers.

The source electrode 173 and the drain electrode 175 may be positioned on the channel layer 132. The source electrode 173 and the drain electrode 175 may be spaced apart from each other in the second direction D2, and the gate electrode 155 and the gate semiconductor layer 152 may be positioned between the source electrode 173 and the drain electrode 175. The gate electrode 155 and the gate semiconductor layer 152 may be spaced apart from the source electrode 173 and the drain electrode 175 in the second direction D2. The source electrode 173 may be electrically connected to the channel layer 132 on one side of the gate electrode 155. The drain electrode 175 may be electrically connected to the channel layer 132 on the other side of the gate electrode 155. The source electrode 173 and the drain electrode 175 may be positioned on the outside of the drift region DTR of the channel layer 132. The interface between the source electrode 173 and the channel layer 132 may be one edge of the drift region DTR. Similarly, the interface between the drain electrode 175 and the channel layer 132 may be the other edge of the drift region DTR. However, the present disclosure is not limited thereto, and the source electrode 173 and the drain electrode 175 may not be positioned outside the drift region DTR of the channel layer 132. In this case, the channel layer 132 may not be recessed, and the source electrode 173 and the drain electrode 175 may be positioned on the upper surface of the channel layer 132. The bottom surfaces of the source electrode 173 and the drain electrode 175 may abut the upper surface of the channel layer 132. Further, the barrier layer 136 may not be recessed, and the source electrode 173 and the drain electrode 175 may be positioned on the upper surface of the barrier layer 136. In other words, the lower surfaces of the source electrode 173 and the drain electrode 175 may abut the upper surface of the barrier layer 136. In an embodiment, the portions of the channel layer 132 that abut the source electrode 173 and the drain electrode 175 may be doped with an impurity at a high concentration. In this case, carriers passing through the 2-dimensional electron gas 134 may be transferred to the source electrode 173 and the drain electrode 175 through the portions of the channel layer 132 doped with the impurity at the high concentration, i.e., the upper portions of the 2-dimensional electron gas 134. The source electrode 173 and the drain electrode 175 may not be in direct contact with the 2-dimensional electron gas 134 in a horizontal direction. The horizontal direction may refer to a direction parallel with the upper surface of the channel layer 132 or the barrier layer 136.

The source electrode 173 and the drain electrode 175 may extend in the first direction D1 in a plan view. In other words, the source electrode 173 and the drain electrode 175 may have a bar shape extending along the first direction D1 in a plan view. The source electrode 173 and the drain electrode 175 may extend in directions parallel with each other. The source electrode 173 and the drain electrode 175 may extend in directions parallel with the gate electrode 155.

The source electrode 173 and the drain electrode 175 may contain a conductive material. For example, the source electrode 173 and the drain electrode 175 may contain a metal, a metal alloy, a conductive metal nitride, a metal silicide, a doped semiconductor material, a conductive metal oxide, or a conductive metal oxynitride. For example, the source electrode 173 and the drain electrode 175 may contain titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbo-nitride (TiAIC-N), titanium aluminum carbide (TiAlC), titanium carbide (TiC), tantalum carbo-nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The source electrode 173 and the drain electrode 175 may consist of a single layer or multiple layers. The source electrode 173 and the drain electrode 175 may be in ohmic contact with the channel layer 132. The regions in the channel layer 132 which are in contact with the source electrode 173 and the drain electrode 175 may be doped at a relatively higher concentration as compared to the other region of the channel layer 132.

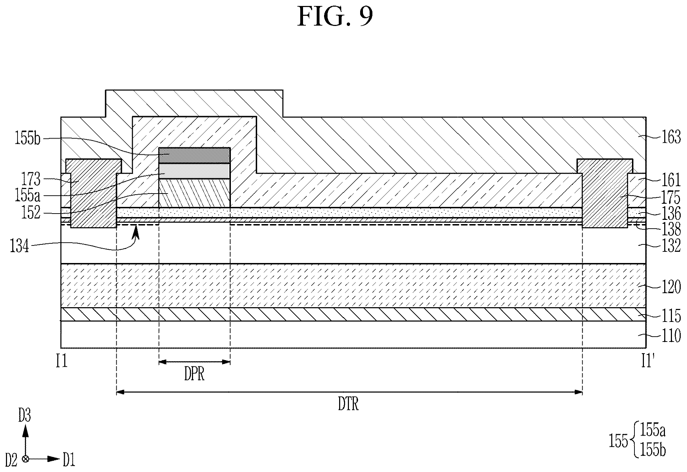

FIG. 9 is a cross-sectional view illustrating a semiconductor device according to an embodiment. Since the semiconductor device shown in FIG. 9 have many portions identical to those of the above embodiments, the following description will be made with a focus on the differences from the above embodiments. Specifically, the semiconductor device according to the embodiment may be partially different from the above embodiments in that it does not include the first intermediate layer 157a described with reference to FIGS. 1 to 4.

Referring to FIG. 9, in the semiconductor device according to the embodiment, a gate electrode 155 may include a lower layer 155a, and an upper layer 155b that is positioned on the lower layer 155a. In the embodiment, the lower layer 155a may contact the upper layer 155b with no intervening layer between the lower layer 155a and the upper layer 155b. The first intermediate layer 157a described with reference to FIGS. 1 to 4 may not be positioned in the gate electrode 155. In the embodiment, the upper surface of the lower layer 155a may abut the lower surface of the upper layer 155b.

In the embodiment, each of the lower layer 155a and the upper layer 155b may contain a metal nitride. In the embodiment, the atomic ratio (M/N) of metal to nitrogen of the metal nitride contained in the upper layer 155b may be larger than the atomic ratio (M/N) of metal to nitrogen of the metal nitride contained in the lower layer 155a. In the embodiment, the atomic ratio (M/N) of metal to nitrogen in each of the lower layer 155a and the upper layer 155b may be constant in the third direction D3 (see FIG. 5), or may gradually increase along the third direction D3 (see FIGS. 6 to 8).

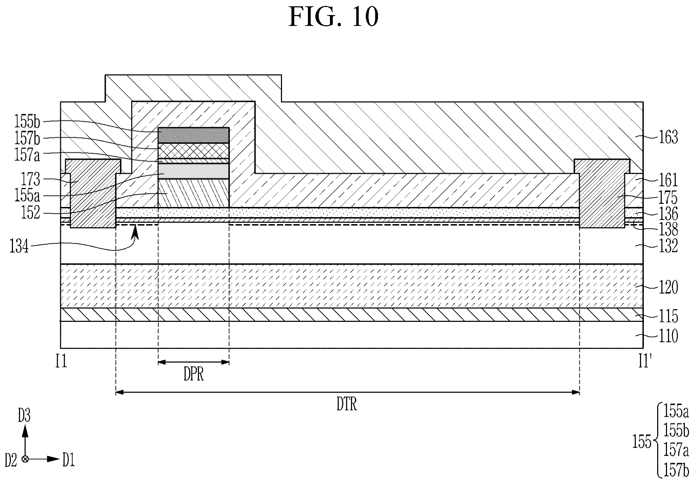

FIG. 10 is a cross-sectional view illustrating a semiconductor device according to an embodiment. Since the semiconductor device shown in FIG. 10 have many portions identical to those of the above embodiments, the following description will be made with a focus on the differences from the above embodiments. Specifically, the semiconductor device according to the embodiment may be partially different from the above embodiments in that the gate electrode 155 further includes a second intermediate layer 157b.

Referring to FIG. 10, the second intermediate layer 157b may be positioned between the lower layer 155a and the upper layer 155b. In the embodiment, the second intermediate layer 157b may be positioned directly below the upper layer 155b. The second intermediate layer 157b may be positioned on the first intermediate layer 157a. In the embodiment, the second intermediate layer 157b may be positioned between the first intermediate layer 157a and the upper layer 155b. In the embodiment, the thickness of the second intermediate layer 157b in the third direction D3 may be larger than the thickness of the first intermediate layer 157a in the third direction D3.

In the embodiment, the second intermediate layer 157b may contain a metal nitride. In some embodiments, the second intermediate layer 157b may contain titanium nitride (TiN). In the embodiment, the atomic ratio (M/N) of metal to nitrogen of the metal nitride contained in the second intermediate layer 157b may be a value larger than the atomic ratio (M/N) of metal to nitrogen in the lower layer 155a. In the embodiment, the atomic ratio (M/N) of metal to nitrogen of the metal nitride contained in the second intermediate layer 157b may be a value smaller than the atomic ratio (M/N) of metal to nitrogen in the upper layer 155b. In an embodiment, a material of the second intermediate layer 157b may be a conductive metal nitride layer, each of the lower layer 155a and the upper layer 155b may be a conductive metal nitride layer with different atomic ratios of metal to nitrogen. In a case that conductive metal nitrides in the second intermediate layer 157b, the lower layer 155a, and the upper layer 155b include a non-metal element such as silicon (Si), a number of the non-metal element atoms and a number of the metal atoms are counted as a number of non-nitrogen atoms to calculate the atomic ratio. The material of the metal nitride layer of the second intermediate layer 157b may have an atomic ratio of metal to nitrogen, which is greater than an atomic ratio of a metal nitride of the metal nitride layer of the lower layer 155a, and which is smaller than an atomic ratio of a metal nitride of the metal nitride layer of the upper layer 155b.

In the embodiment, the atomic ratio (M/N) of metal to nitrogen in the second intermediate layer 157b may be constant in the third direction D3 (see FIG. 5), or may gradually increase along the third direction D3 (see FIGS. 6 to 8).

In the embodiment, the resistivity of the metal nitride contained in the second intermediate layer 157b may be higher than the resistivity of the metal nitride contained in the lower layer 155a and lower than the resistivity of the metal nitride contained in the upper layer 155b.

In another embodiment, the second intermediate layer 157b may contain a material having lower resistivity than the lower layer 155a, the upper layer 155b, and the first intermediate layer 157a. For example, the second intermediate layer 157b may contain a conductive material. For example, the second intermediate layer 157b may contain a metal material. For example, the second intermediate layer 157b may contain aluminum (Al). When the second intermediate layer 157b contains a material having low resistivity (for example, a conductive material), the electrical conductivity of the gate electrode 155 can increase, and accordingly, the switching speed of the semiconductor device according to the embodiment can be improved.

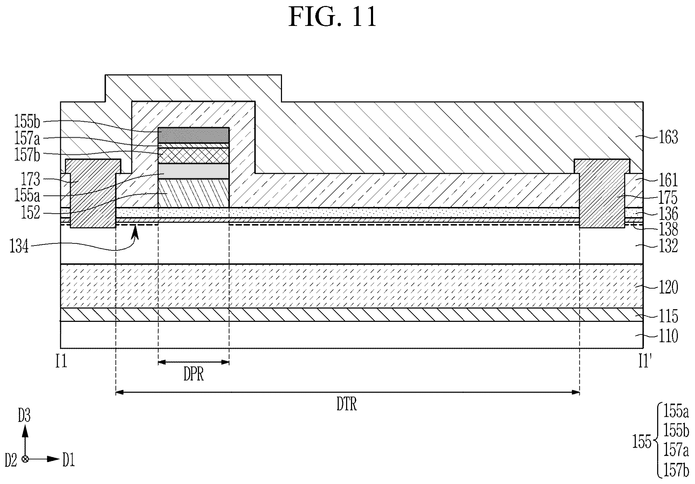

FIG. 11 is a cross-sectional view illustrating a semiconductor device according to an embodiment. Since the semiconductor device shown in FIG. 11 have many portions identical to those of the above embodiments, the following description will be made with a focus on the differences from the above embodiments. For example, the semiconductor device according to the embodiment may be partially different from the above embodiments in the position of the second intermediate layer 157b.

Referring to FIG. 11, the second intermediate layer 157b may be positioned between the lower layer 155a and the upper layer 155b. In the embodiment, the second intermediate layer 157b may be positioned directly below the first intermediate layer 157a. In the embodiment, the second intermediate layer 157b may be positioned directly on the lower layer 155a. For example, in the embodiment described with reference to FIG. 10, the second intermediate layer 157b is positioned between the upper layer 155b and the first intermediate layer 157a. The present disclosure is not limited thereto. In an embodiment, the second intermediate layer 157b may be positioned between the first intermediate layer 157a and the lower layer 155a.

Since the material contained in the second intermediate layer 157b and the effect of having the second intermediate layer 157b are similar to those of the embodiment described with reference to FIG. 10, a detailed description thereof will not be made.

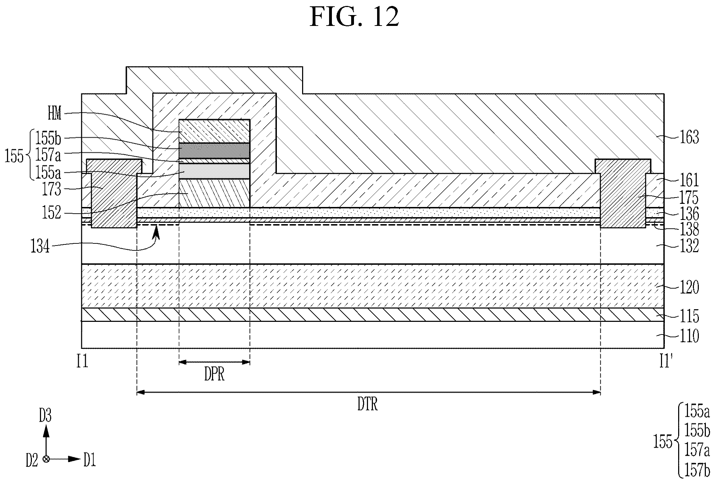

FIG. 12 is a cross-sectional view illustrating a semiconductor device according to an embodiment. Since the semiconductor device shown in FIG. 12 have many portions identical to those of the above embodiments, the following description will be made with a focus on the differences from the above embodiments. For example, the semiconductor device according to the embodiment may be partially different from the above embodiments in that it includes a hard mask layer HM.

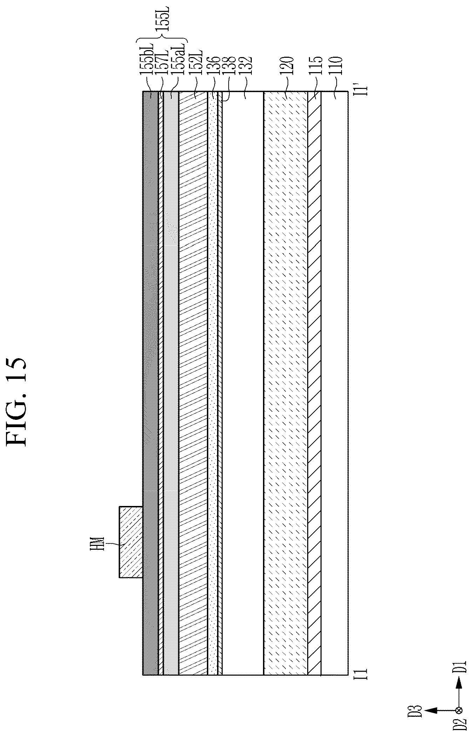

The hard mask layer HM may be a hard mask used to perform patterning on a gate electrode material layer 155L (see FIG. 15) or a gate semiconductor material layer 152L (see FIG. 15) during the process of forming the gate electrode 155 to be described below. The hard mask layer HM may be partially or entirely removed depending on an etching condition during etching the gate electrode material layer 155L or depending on a cleaning condition after the etching. As an example, the hard mask layer HM may contain silicon oxide (SiO₂), silicon nitride (SiN_{X}), silicon oxynitride (SiON), or a combination thereof.

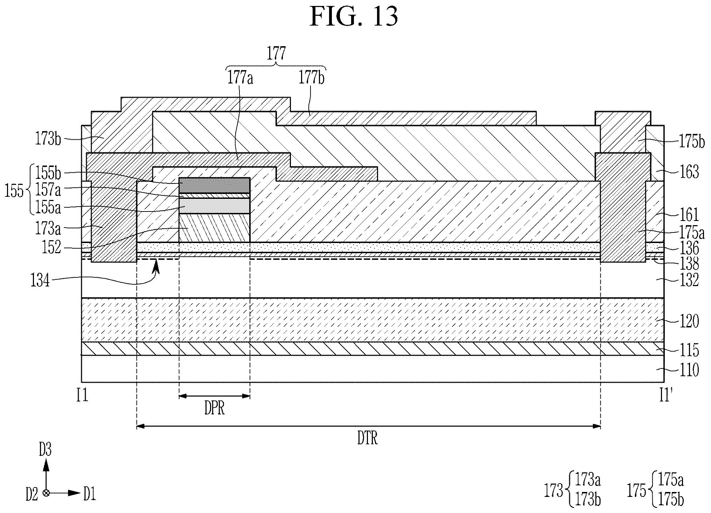

FIG. 13 is a cross-sectional view illustrating a semiconductor device according to an embodiment. Since the semiconductor device shown in FIG. 13 have many portions identical to those of the above embodiments, the following description will be made with a focus on the differences from the above embodiments. For example, the semiconductor device according to the embodiment may be partially different from the above embodiments in that the source electrode 173 includes a lower source electrode 173a and an upper source electrode 173b, the drain electrode 175 includes a lower drain electrode 175a and an upper drain electrode 175b, and the semiconductor device further includes a field dispersion layer 177.

The source electrode 173 may include the lower source electrode 173a and the upper source electrode 173b. The upper source electrode 173b may be positioned on the lower source electrode 173a. The lower source electrode 173a may directly abut the channel layer 132, and be electrically connected to the channel layer 132. The upper source electrode 173b may not directly abut the channel layer 132, and be electrically connected to the channel layer 132 through the lower source electrode 173a.

The drain electrode 175 may include the lower drain electrode 175a and the upper drain electrode 175b. The upper drain electrode 175b may be positioned on the lower drain electrode 175a. The lower drain electrode 175a may directly abut the channel layer 132 and be electrically connected to the channel layer 132. The upper drain electrode 175b may not directly abut the channel layer 132, and be electrically connected to the channel layer 132 through the lower drain electrode 175a.

The lower source electrode 173a and the lower drain electrode 175a may be positioned on the first protective layer 161. The lower source electrode 173a and the lower drain electrode 175a may be positioned between the first protective layer 161 and the second protective layer 163. On opposite sides of the gate electrode 155, trenches may be formed so as to pass through the first protective layer 161 and the barrier layer 136, recess the upper surface of the channel layer 132, and be positioned apart from each other. Inside the trenches positioned on both sides of the gate electrode 155, the lower source electrode 173a and the lower drain electrode 175a may be positioned. The lower source electrode 173a and the lower drain electrode 175a may be formed so as to fill the trenches. Inside the trenches, the lower source electrode 173a and the upper drain electrode 175b may abut the channel layer 132 and the barrier layer 136. The channel layer 132 may constitute the bottom surfaces and side walls of the trenches, and the barrier layer 136 may constitute the side walls of the trenches. Accordingly, the lower source electrode 173a and the lower drain electrode 175a may abut the upper surface and side surfaces of the channel layer 132. Further, the lower source electrode 173a and the lower drain electrode 175a may abut the side surfaces of the barrier layer 136. In other words, the lower source electrode 173a and the lower drain electrode 175a may cover the side surfaces of the channel layer 132 and the barrier layer 136. The upper surfaces of the lower source electrode 173a and the lower drain electrode 175a may be positioned higher than the upper surface of the first protective layer 161. Further, at least one of the lower source electrode 173a and the lower drain electrode 175a may cover at least a portion of the upper surface of the first protective layer 161. On the lower source electrode 173a and the lower drain electrode 175a, the second protective layer 163 may be positioned. At least some portions of the lower source electrode 173a and the lower drain electrode 175a may be covered by the second protective layer 163.

The semiconductor device may include a first field dispersion layer 177a that is positioned on the first protective layer 161. The first field dispersion layer 177a may be positioned between the lower source electrode 173a and the lower drain electrode 175a. The gate electrode 155 may be covered by the first field dispersion layer 177a. The first field dispersion layer 177a may be electrically connected to the lower source electrode 173a. For example, the first field dispersion layer 177a may be connected to the lower source electrode 173a. The first field dispersion layer 177a may contain the same material as that of the lower source electrode 173a. The first field dispersion layer 177a and the lower source electrode 173a may be positioned in the same layer. The first field dispersion layer 177a may be formed simultaneously with the lower source electrode 173a in the same process. The interface between the first field dispersion layer 177a and the lower source electrode 173a may not be clear, and the first field dispersion layer 177a may be formed integrally with the lower source electrode 173a. However, the present disclosure is not limited thereto, and the first field dispersion layer 177a may be an individual constituent element separated from the lower source electrode 173a. Further, the first field dispersion layer 177a and the lower source electrode 173a may be positioned in different layers, and may be formed in different processes. In some embodiments, the first field dispersion layer 177a may be electrically connected to the gate electrode 155. For example, an opening may be formed in the first protective layer 161 so as to overlap the gate electrode 155, and the first field dispersion layer 177a may be connected to the gate electrode 155 through the opening. In this case, the first field dispersion layer 177a may not be connected to the source electrode 173.

The semiconductor device may include a second field dispersion layer 177b that is positioned on the second protective layer 163. The second field dispersion layer 177b may constitute the field dispersion layer together with the first field dispersion layer 177a. The second field dispersion layer 177b may be positioned between the upper source electrode 173b and the upper drain electrode 175b. The second field dispersion layer 177b may overlap the gate electrode 155 in the third direction DR3. The second field dispersion layer 177b may overlap the first field dispersion layer 177a in the third direction DR3. The gate electrode 155 and the first field dispersion layer 177a may be covered by the second field dispersion layer 177b. The second field dispersion layer 177b may be wider than the first field dispersion layer 177a. The second field dispersion layer 177b may entirely cover the first field dispersion layer 177a. However, the present disclosure is not limited thereto, and the widths, positional relationship, and so on of the first field dispersion layer 177a and the second field dispersion layer 177b may be variously changed. The second field dispersion layer 177b may be electrically connected to the source electrode 173. For example, the second field dispersion layer 177b may be connected to the upper source electrode 173b. The second field dispersion layer 177b may contain the same material as that of the upper source electrode 173b. The second field dispersion layer 177b and the upper source electrode 173b may be positioned in the same layer. The second field dispersion layer 177b may be formed simultaneously with the upper source electrode 173b in the same process. The interface between the second field dispersion layer 177b and the upper source electrode 173b may not be clear, and the second field dispersion layer 177b may be formed integrally with the upper source electrode 173b. However, the present disclosure is not limited thereto, and the second field dispersion layer 177b may be an individual constituent element separated from the upper source electrode 173b. Further, the second field dispersion layer 177b and the upper source electrode 173b may be positioned in different layers, and may be formed in different processes, respectively.

In some embodiments, at least one of the first field dispersion layer 177a and the second field dispersion layer 177b may be omitted. For example, the semiconductor device may include the first field dispersion layer 177a but may not include the second field dispersion layer 177b. Alternatively, the semiconductor device may include the second field dispersion layer 177b but may not include the first field dispersion layer 177a.

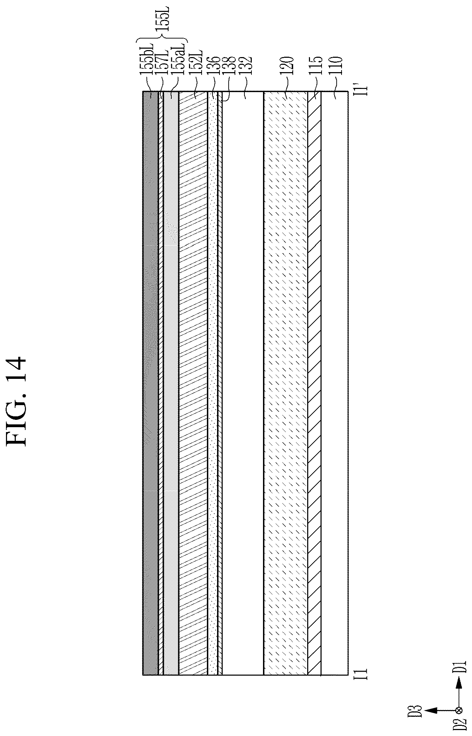

A method of manufacturing a semiconductor device according to an embodiment will be described with reference to FIGS. 14 to 20. Further, FIGS. 1 to 4 described above may be referred to together.

FIGS. 14 to 20 are cross-sectional views illustrating processes of manufacturing a semiconductor device according to an embodiment in the order of the processes.

As shown in FIG. 14, on a substrate 110, a seed layer 115, a buffer layer 120, a channel layer 132, a spacer layer 138, and a barrier layer 136 may be sequentially formed. Further, on the barrier layer 136, a gate semiconductor material layer 152L and gate electrode material layers 155aL, 157L, and 155bL may be formed.

As an example, the seed layer 115, the buffer layer 120, the channel layer 132, the spacer layer 138, the barrier layer 136, and the gate semiconductor material layer 152L may be sequentially formed using an epitaxial growth method. On the substrate 110, the seed layer 115 may be first formed, and on the seed layer 115, the buffer layer 120 may be formed. The buffer layer 120 may include a superlattice layer and a high-resistivity layer. On the buffer layer 120, the channel layer 132 may be formed, and on the channel layer 132, the spacer layer 138 and the barrier layer 136 may be formed, and on the barrier layer 136, the gate semiconductor material layer 152L may be formed.

For example, as equipment for growing the seed layer 115, the buffer layer 120, the channel layer 132, the spacer layer 138, the barrier layer 136, and the gate semiconductor material layer 152L, metal organic chemical vapor deposition (MOCVD) equipment, hydride vapor phase epitaxy (HVPE) equipment, or molecular beam epitaxy (MBE) equipment may be used.

The seed layer 115, the buffer layer 120, the channel layer 132, the spacer layer 138, the barrier layer 136, and the gate semiconductor material layer 152L may consist of the same elements, but the material composition ratios of the individual layers may be different from one another in view of the roles of the individual layers and the performance required for the semiconductor device.

As an example, the substrate 110 may contain Si, the seed layer 115 may contain AIN, and the superlattice layer of the buffer layer 120 may have a structure in which layers consisting of AlGaN and layers consisting of GaN are alternately stacked. The high-resistivity layer of the buffer layer 120 may contain GaN, the channel layer 132 may contain GaN, the spacer layer 138 may contain AIN, and the barrier layer 136 may contain AlGaN. The channel layer 132, the spacer layer 138, and the barrier layer 136 may or may not be doped with an impurity. The gate semiconductor material layer 152L may contain GaN, and may be doped with an impurity. The gate semiconductor material layer 152L may be doped with a p-type impurity, for example, magnesium (Mg).

Since the lattice structure of Si and the lattice structure of GaN are different, it may not be easy to grow the channel layer 132, which consists of GaN, directly on the substrate 110 which consists of Si. For this reason, after the formation of the seed layer 115, the buffer layer 120 is formed first on the substrate 110, the channel layer 132 may be formed such that the lattice structure of the channel layer 132 can be stably formed.

Subsequently, on the gate semiconductor material layer 152L, the gate electrode material layers 155aL, 157L, and 155bL may be sequentially formed.

As an example, a lower material layer 155aL and an upper material layer 155bL of the gate electrode material layer 155L may be formed using a deposition process. For example, the lower material layer 155aL and the upper material layer 155bL may be formed using E-beam evaporation, sputtering, physical vapor deposition (PVD), thermal chemical vapor deposition (thermal CVD), low-pressure chemical vapor deposition (LP-CVD), plasma-enhanced chemical vapor deposition (PE-CVD), or atomic layer deposition (ALD), but are not limited thereto.

For example, when the lower material layer 155aL and the upper material layer 155bL are formed of titanium nitride (TiN), for deposition of titanium nitride (TiN), argon (Ar) and nitrogen (N₂) may be used as a sputtering gas and a reactivity gas, respectively. The substrate temperature may be 27°C to 600°C, the target power may be 50 W to 1000 W, the sputtering gas pressure may be 0.1 Pa to 1.0 Pa, the flow rate of argon (Ar) may be 0 sccm to 100 sccm (0 Pa·m³/sec to 1.69× 10⁻¹ Pa·m³/sec), and the flow rate of the nitrogen (N₂) gas may be 0 sccm to 100 sccm (0 Pa·m³/sec to 1.69 × 10⁻¹ Pa·m³/sec).

In this case, the atomic ratio (N/Ti) of nitrogen (N) to titanium (Ti) in the titanium nitride (TiN) may be adjusted by the mixing ratio of argon and nitrogen which are introduced during the sputtering. Accordingly, the lower material layer 155aL and the upper material layer 155bL may be formed so as to be different in the atomic ratio (Ti/N) of titanium (Ti) to nitrogen (N) in the titanium nitride (TiN).

In the embodiment, the intermediate material layer 157L may be grown using, for example, metal organic chemical vapor deposition (MOCVD), hydride vapor phase epitaxy (HVPE), or molecular beam epitaxy (MBE). A specific forming method is similar to the method of growing the seed layer 115, the buffer layer 120, the channel layer 132, the spacer layer 138, the barrier layer 136, and the gate semiconductor material layer 152L described above, and thus, a detailed description thereof will not be made.

Subsequently, a gate semiconductor layer 152 and a gate electrode 155 are formed by etching the gate semiconductor material layer 152L and the gate electrode material layer 155L, respectively.

First, as shown in FIG. 15, a hard mask pattern HM may be formed on the gate electrode material layer 155L. For example, the hard mask pattern HM may contain a spin-on hard mask (SOH) material. Alternatively, the hard mask pattern HM may contain silicon oxide, silicon nitride, silicon oxynitride, or a combination thereof. The hard mask pattern HM may be formed by forming a hard mask layer on the gate electrode material layer 155L and then performing patterning on the hard mask layer.

Subsequently, as shown in FIG. 16, the gate semiconductor layer 152 and the gate electrode 155 may be formed by performing patterning on the gate semiconductor material layer 152L and the gate electrode material layer 155L using the hard mask layer HM as a mask.

In the embodiment, dry etching including a reactive ion etching process may be performed using an etching gas on the gate semiconductor material layer 152L and the gate electrode material layer 155L. The etching gas may contain fluoride gas or chloride gas. For example, the fluoride gas may contain CHF₃, CF₄, or a mixture thereof, and the chloride gas may contain Cl₂, BCl₃, or a mixture thereof.

In some embodiments, after the etching of the gate semiconductor material layer 152L and the gate electrode material layer 155L, byproduct removal and a process of cleaning the substrate 110 may be performed. As an example, the byproduct removal may be performed through an ashing or strip process. An ashing process and a strip process may be sequentially performed. For example, first, an ashing process for removal may be performed through an oxygen (O₂) plasma treatment process or an ozone (O₃) treatment process, and then, a strip process may be performed. In addition to the ashing process or the strip process, the process of cleaning the substrate 110 may be performed. As an example, the cleaning process may include dry cleaning using NH₃ gas, NF₃ gas, or NF₃ plasma, or a wet cleaning process using chemical etchant such as HF and BOE which stands for Buffered Oxide Etch. Thereafter, the substrate 110 may be cleaned using a cleaning solution such as ammonium hydroxide (NH₄OH). In this process, the hard mask layer HM remaining on the gate electrode 155 may be removed.

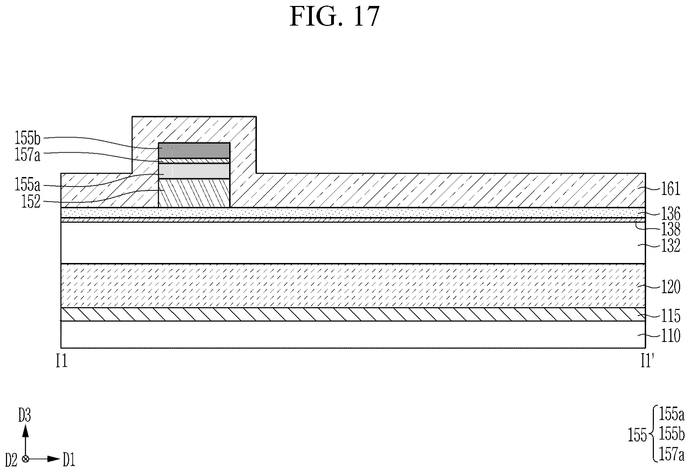

As shown in FIG. 17, on the barrier layer 136, the gate semiconductor layer 152, and the gate electrode 155, a first protective layer 161 may be formed. The first protective layer 161 may be formed using a deposition process. The first protective layer 161 may contain an insulating material. For example, the first protective layer 161 may contain an insulating material such as SiO₂, SiN, SiON, and Al₂O₃. The first protective layer 161 is shown as a single layer in the drawing, but may consist of multiple layers in some cases. In this case, the first protective layer 161 may be formed by sequentially depositing different materials. Alternatively, the first protective layer 161 may be formed using the same material so as to consist of multiple layers having different characteristics by varying the deposition condition. For example, a portion of the first protective layer 161 adjacent to the barrier layer 136 may consist of an insulating material having significantly higher quality than the other portion. This is for preventing electrons forming a channel from being trapped inside the channel layer 132 positioned below the barrier layer 136. The portion of the first protective layer 161 which abuts the barrier layer 136 may consist of SiO₂.

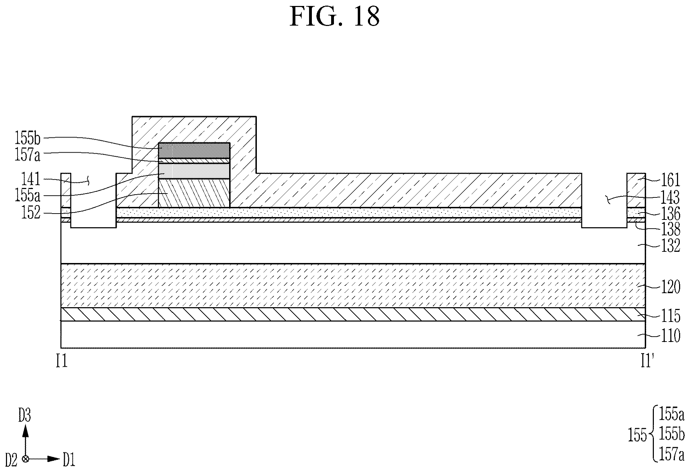

As shown in FIG. 18, a first trench 141 and a second trench 143 may be formed by performing patterning on the first protective layer 161 using photolithography and etching processes. In this case, the patterning may also be performed on the barrier layer 136, the spacer layer 138, and the channel layer 132.

For example, a photoresist pattern may be formed on the first protective layer 161, and etching may be sequentially performed on the first protective layer 161, the barrier layer 136, the spacer layer 138, and the channel layer 132, using the photoresist pattern as a mask. The first trench 141 and the second trench 143 may penetrate the first protective layer 161, the spacer layer 138, and the barrier layer 136. The upper surface of the channel layer 132 may be recessed. The channel layer 132 may not be penetrated by the first trench 141 or the second trench 143. In other words, the depth at which the upper surface of the channel layer 132 is recessed may be smaller than the overall thickness of the channel layer 132. In this case, the depth at which the upper surface of the channel layer 132 is recessed may be significantly smaller than the overall thickness of the channel layer 132. For example, the depth at which the upper surface of the channel layer 132 is recessed may be about 0% to about 30% of the overall thickness of the channel layer 132. Also, the depth at which the upper surface of the channel layer 132 is recessed may be smaller than the thickness of the barrier layer 136. However, the present disclosure is not limited thereto, and the depth at which the upper surface of the channel layer 132 is recessed may be variously changed. By the first trench 141 and the second trench 143, the side surfaces of the first protective layer 161, the spacer layer 138, and the barrier layer 136 may be exposed to the outside, and the upper surface and side surfaces of the channel layer 132 may be exposed. The channel layer 132 may constitute the bottom surfaces and side walls of the first trench 141 and the second trench 143, and the spacer layer 138 and the barrier layer 136 may constitute the side walls of the first trench 141 and the second trench 143.

The first trench 141 and the second trench 143 may be spaced apart from each other. The first trench 141 and the second trench 143 may be positioned on opposite sides of the gate electrode 155. The first trench 141 may be positioned on one side of the gate electrode 155 so as to be spaced apart from the gate electrode 155. The second trench 143 may be positioned on the other side of the gate electrode 155 so as to be spaced apart from the gate electrode 155. The separation distance of the first trench 141 from the gate electrode 155 may be smaller than the separation distance of the second trench 143 from the gate electrode 155. In the drawing, the first trench 141 and the second trench 143 may be substantially the same as each other in a shape, a width, and a depth, but the present disclosure is not limited thereto. The shapes of the first trench 141 and the second trench 143 may be variously changed.

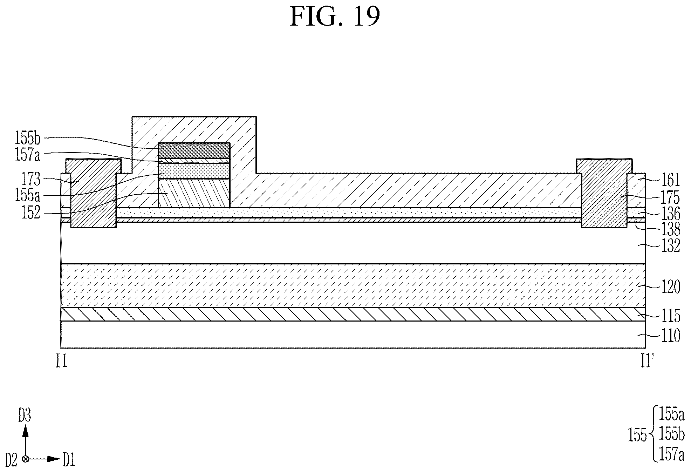

As shown in FIG. 19, a source electrode 173 and a drain electrode 175 may be formed so as to fill the first trench 141 and the second trench 143, respectively.

The source electrode 173 may be formed so as to fill the first trench 141 (see FIG. 18). Inside the first trench 141 (see FIG. 18), the source electrode 173 may abut the channel layer 132, the spacer layer 138, and the barrier layer 136. The source electrode 173 may abut the side surfaces of the channel layer 132, the spacer layer 138, and the barrier layer 136. The source electrode 173 may cover the side surfaces of the channel layer 132, the spacer layer 138, and the barrier layer 136. The source electrode 173 may be electrically connected to the channel layer 132 through the first trench 141.

The drain electrode 175 may be formed so as to fill the second trench 143 (see FIG. 18). Inside the second trench 143 (see FIG. 18), the drain electrode 175 may abut the channel layer 132, the spacer layer 138, and the barrier layer 136. The drain electrode 175 may abut the side surfaces of the channel layer 132, the spacer layer 138, and the barrier layer 136. The drain electrode 175 may cover the side surfaces of the channel layer 132, the spacer layer 138, and the barrier layer 136. The drain electrode 175 may be electrically connected to the channel layer 132 through the second trench 143. The upper surface of the drain electrode 175 may protrude from the upper surface of the first protective layer 161.

At a portion inside the channel layer 132 adjacent to the barrier layer 136, a 2-dimensional electron gas 134 may be formed. The 2-dimensional electron gas 134 may be positioned at the interface between the channel layer 132 and the barrier layer 136. The 2-dimensional electron gas 134 may be positioned in the drift region DTR (see FIG. 2) between the source electrode 173 and the drain electrode 175. The gate semiconductor layer 152 having an energy band gap different from that of the barrier layer 136 may form a depletion region DPR (see FIG. 2) inside the channel layer 132. Accordingly, the semiconductor device according to the embodiment may have a normally-off characteristic. In other words, the semiconductor device according to the embodiment may be a normally-off high electron mobility transistor (HEMT)(i.e., an enhancement-mode HEMT). In the gate-off state, the 2-dimensional electron gas 134 may be positioned inside the drift region DTR except for the depletion region DPR (see FIG. 2) of the channel layer 132. In the gate-on state, the flow of the 2-dimensional electron gas 134 continues inside the depletion region DPR (see FIG. 2), and thus the 2-dimensional electron gas 134 may be positioned throughout the inside of the drift region DTR.

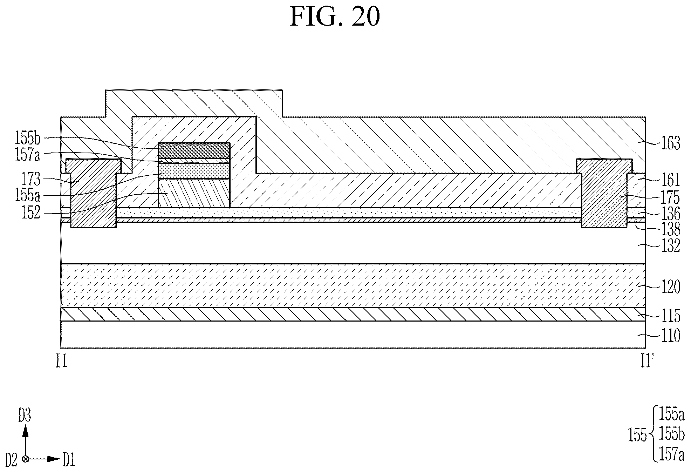

As shown in FIG. 20, on the first protective layer 161, a second protective layer 163 may be formed. The second protective layer 163 may cover the source electrode 173 and the drain electrode 175.

While this disclosure has been described in connection with what is presently considered to be practical embodiments, it is to be understood that the disclosure is not limited to the disclosed embodiments. On the contrary, it is intended to cover various modifications and equivalent arrangements included within the scope of the appended claims.

Embodiments are set out in the following clauses:
Clause 1. A semiconductor device comprising:
   a substrate;
   a channel layer that is positioned on the substrate;
   a barrier layer that is positioned on the channel layer;
   a gate electrode that includes a first metal nitride layer which is positioned on the barrier layer, a second metal nitride layer which is positioned on the first metal nitride layer, and a first intermediate layer which is positioned between the first metal nitride layer and the second metal nitride layer, wherein the first metal nitride layer, the first intermediate layer, and the second metal nitride layer are stacked in a vertical direction perpendicular to an upper surface of the substrate; and
   a source electrode and a drain electrode that are connected to the channel layer and positioned on opposite sides of the gate electrode,
   wherein an electrical resistivity of the first intermediate layer is higher than an electrical resistivity of each of the first metal nitride layer and the second metal nitride layer.
Clause 2.The semiconductor device according to clause 1,
   wherein a thickness of the first intermediate layer is larger than 0 nm and smaller than 3 nm.
Clause 3. The semiconductor device of clause 1 or clause 2,
   wherein a metal nitride of the second metal nitride layer has an atomic ratio of metal to nitrogen larger than an atomic ratio of metal to nitrogen of a metal nitride of the first metal nitride layer.
Clause 4.The semiconductor device of any of clauses 1 to 3,
   wherein a metal nitride of the first metal nitride layer has an atomic ratio of metal to nitrogen which is larger than or equal to 0.8 and smaller than or equal to 0.9, and
   wherein a metal nitride of the second metal nitride layer has an atomic ratio of metal to nitrogen which is larger than or equal to 1.2 and smaller than or equal to 1.3.

## Claims

1. A semiconductor device comprising:
a substrate (110);
a channel layer (132) that is positioned on the substrate (110);
a barrier layer (136) that is positioned on the channel layer (132);
a gate electrode (155) including a first metal nitride layer (155a) which is positioned on the barrier layer (136) and a second metal nitride layer (155b) which is positioned on the first metal nitride layer (155a); and
a source electrode (173) and a drain electrode (175) that are connected to the channel layer (132) and positioned on opposite sides of the gate electrode (155),
wherein a metal of the first metal nitride layer (155a) is the same as a metal of the second metal nitride layer (155b),
wherein a metal nitride of the first metal nitride layer (155a) has a first atomic ratio of at least one element other than nitrogen to nitrogen,
wherein a metal nitride of the second metal nitride layer (155b) has a second atomic ratio of at least one element other than nitrogen to nitrogen, and
wherein the second atomic ratio is greater than the first atomic ratio.

2. The semiconductor device of claim 1,
wherein the gate electrode (155) further includes a first intermediate layer (157a) which is positioned in a space between the first metal nitride layer (155a) and the second metal nitride layer (155b),
wherein the first intermediate layer (157a) contains a semiconductor material or an insulating material, and
wherein the first metal nitride layer (155a), the first intermediate layer (157a), and the second metal nitride layer (155b) are stacked in a vertical direction (D3) perpendicular to an upper surface of the substrate (110).

3. The semiconductor device of claim 2,
wherein an electrical resistivity of the first intermediate layer (157a) is higher than an electrical resistivity of each of the first metal nitride layer (155a) and the second metal nitride layer (155b).

4. The semiconductor device of claim 2 or claim 3,
wherein a thickness of the first intermediate layer (157a) is larger than 0 nm and smaller than 3 nm.

5. The semiconductor device of any of claims 2-4,
wherein the first intermediate layer (157a) contains a III-V compound semiconductor material.

6. The semiconductor device of any of claims 2-5,
wherein the first intermediate layer (157a) contains aluminum nitride (AIN).

7. The semiconductor device of any of claims 2-4,
wherein the first intermediate layer (157a) contains at least one of silicon oxide (SiO₂) and silicon nitride (SiN_{X}).

8. The semiconductor device of any preceding claim, further comprising:
a gate semiconductor layer (152) disposed in a space between the gate electrode (155) and the barrier layer (136),
wherein the gate semiconductor layer (152) is doped with a p-type impurity,
wherein the first metal nitride layer (155a) is a TiN layer, and
wherein the first atomic ratio is larger than or equal to 0.7 and smaller than or equal to 1.0.

9. The semiconductor device of any preceding claim,
wherein the second atomic ratio of the second metal nitride layer (155b) is larger than or equal to 1.1 and smaller than or equal to 1.4.

10. The semiconductor device of any preceding claim,
wherein the gate electrode (155) further includes a second intermediate layer which is positioned in a space between the first metal nitride layer and the second metal nitride layer,
wherein the second intermediate layer (157b) is a third metal nitride layer, wherein a metal nitride of the third metal nitride layer has a third atomic ratio of at least one element other than nitrogen to nitrogen, and
wherein the third atomic ratio of the third metal nitride layer is smaller than the second atomic ratio of the second metal nitride layer (155b) and larger than the first atomic ratio of the first metal nitride layer (155a).

11. The semiconductor device of any preceding claim,
wherein the gate electrode (155) further includes a third intermediate layer which is positioned in a space between the first metal nitride layer (155a) and the second metal nitride layer (155b), and
wherein an electrical resistivity of the third intermediate layer is lower than an electrical resistivity of each of the first metal nitride layer (155a) and the second metal nitride layer (155b).

12. The semiconductor device of claim 11,
wherein a material of the third intermediate layer is aluminum (Al).

13. The semiconductor device of any preceding claim,
wherein the first atomic ratio of the first metal nitride layer (155a) gradually increases in a direction from a lower surface of the first metal nitride layer (155a) toward an upper surface of the first metal nitride layer (155a).

14. The semiconductor device of any preceding claim,
wherein the second atomic ratio of the second metal nitride layer (155b) gradually increases from a lower surface of the second metal nitride layer (155b) toward an upper surface of the second metal nitride layer (155b).

15. The semiconductor device of any of claims 1-7,
wherein a metal nitride of each of the first metal nitride layer (155a) and the second metal nitride layer (155b) is titanium nitride (TiN), titanium silicon nitride (TiSiN), tantalum nitride (TaN), tantalum silicon nitride (TaSiN), tantalum titanium nitride (TaTiN), titanium aluminum nitride (TiAIN), tantalum aluminum nitride (TaAlN), tungsten nitride (WN), titanium aluminum carbonitride (TiAIC-N), or a combination thereof.
